(19) Europäisches Patentamt
European Patent Office
Office européen des brevets

(11) Veröffentlichungsnummer: **0 337 188 B1**

(12) **EUROPÄISCHE PATENTSCHRIFT**

(45) Veröffentlichungstag der Patentschrift: **07.07.93**

(51) Int. Cl.$^5$: **C08G 8/28**, C08F 8/42, C08G 16/04, G03F 7/012

(21) Anmeldenummer: **89105524.6**

(22) Anmeldetag: **29.03.89**

# (54) In wässrigem Alkali lösliche, Silanylgruppen in der Seitenkette enthaltende Bindemittel, Verfahren zu deren Herstellung sowie lichtempfindliches Gemisch, enthaltend diese Verbindungen.

(30) Priorität: **02.04.88 DE 3811242**

(43) Veröffentlichungstag der Anmeldung: **18.10.89 Patentblatt 89/42**

(45) Bekanntmachung des Hinweises auf die Patenterteilung: **07.07.93 Patentblatt 93/27**

(84) Benannte Vertragsstaaten: **BE CH DE FR GB LI**

(56) Entgegenhaltungen:
**EP-A- 0 129 834**
**EP-A- 0 285 797**
**GB-A- 2 158 450**

**PATENT ABSTRACTS OF JAPAN Banb 12, Nr 28(-471) (2875), 27.01.1988; & JP-A 62177005**

(73) Patentinhaber: **HOECHST AKTIENGESELLSCHAFT**
**Postfach 80 03 20**
**W-6230 Frankfurt am Main 80(DE)**

(72) Erfinder: **Wilharm, Peter, Dr.**
**Am Scheuerling 3**
**W-6200 Wiesbaden(DE)**
Erfinder: **Buhr, Gerhard, Dr,**
**Am Erdbeerstein 28**
**W-6240 Königstein 4(DE)**
Erfinder: **Fuchs, Jürgen**
**Flörsheimer Strasse 40**
**W-6093 Flörsheim-Wicker(DE)**



Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft in wäßrigem Alkali lösliche Bindemittel, die in der Seitenkette Silanylgruppen tragen, ein Verfahren zu deren Herstellung sowie positiv und negativ arbeitende lichtempfindliche Gemische enthaltend diese Bindemittel.

Die Mikrolithographie erfordert insbesondere im Submikronbereich bei steigender Auflösung und gleichzeitig abnehmender Fokustoleranz zur Strukturierung von Substraten mit komplizierter Topographie die Anwendung von Mehrlagensystemen. Dabei wird das Zweilagensystem aufgrund der einfacheren Prozessierbarkeit bevorzugt.

Gewöhnlich befindet sich auf dem Substrat eine komplizierte Topographie, die durch in der Fertigung von mikroelektronischen Schaltkreisen üblichen Prozeßschritte, wie beispielsweise Metallisierung, Oxidabscheidung, Epitaxie etc., hervorgerufen wird.

Beim Zweilagenverfahren wird das topographisch relativ unebene Substrat durch eine sogenannte Planarisierungsschicht eingeebnet. Als Materialien für die Planarisierungsschicht werden beispielsweise Polymere verwendet, die sich im nachfolgenden Plasmaätzprozeß gut ätzen lassen.

Auf die Planarisierungsschicht wird die eigentliche Resistschicht aufgebracht, die bildmäßig belichtet wird. Nach dem Entwickeln der - je nach angewendeten Verfahren (positiv oder negativ arbeitend) - belichteten bzw. nicht belichteten Bereiche wirkt die nicht entfernte Resistschicht als Maske für das Plasmaätzen der darunter jetzt bildmäßig freiliegenden Planarisierungsschicht. Die Resistschicht muß daher plasmaätzbeständig, insbesondere gegenüber Sauerstoff-Plasmen sein, und gleichzeitig auch hochaufgelöste Strukturen zulassen. Die Herstellung hochaufgelöster Strukturen mittels Mehrlagenverfahren, insbesondere Zweilagenverfahren, wird beispielsweise von E. Reichmanis, G. Smolinsky und C.W. Wilkins in Solid State Technology, August 1985, Seite 130, ausführlich beschrieben. Eine Übersicht über lichtempfindliche Schichten auf Planarisierungsschichten gibt beispielsweise Y. Onishi et al. in SPIE, Vol. 539, Advances in Resist Technology and Processing II, S. 62.

Die Plasmaätzbeständigkeit von Bindemitteln, insbesondere die Beständigkeit gegenüber Sauerstoff-Plasmen, kann durch den Einbau von Metallatomen (z.B. Si, Ge, Sn, Ti) erzielt werden. In der Praxis hat sich die Verwendung von Silicium bewährt: Siliciumhaltige Verbindungen sind synthetisch vergleichsweise gut zugänglich, besitzen i.a. eine niedrige Toxizität und stellen keine Kontaminationsquelle bei Prozessen zur Fertigung von mikroelektronischen Schaltkreisen dar. Bisher bekannte siliciumhaltige Bindemittel zeigen an herkömmliche Bindemittel gebundene Polysiloxangruppen (US-A-4,481,049). Photohärtende Polyorganosiloxane zur Beschichtung von Halbleitern werden in der JP-A-590313/1982 beschrieben; photosensitive Polyorganosiloxane mit endständigen Aminogruppen in der JP-A-089955/1987. Polymere mit komplizierter Polysilsesquioxan-Struktur werden in der EP-A-0 232 167 beschrieben, kompliziert aufgebaute und schwierig zu synthetisierende Polysiloxane werden auch in der EP-A-0 231 497 genannt.

Bindemittel dieser Art weisen aber eine zu niedrige Glastemperatur auf, so daß ein Fließen der Resiststrukturen unter thermischer Belastung, wie sie beispielsweise bei Plasmaätzprozessen auftreten kann, und als Folge daraus ein Verlust an Maßhaltigkeit, nicht verhindert werden kann; sie sind aber auch unverträglich mit anderen Bindemitteln, insbesondere mit alkalilöslichen Bindemitteln. Außerdem ist nachteilig ihre niedrige lithographische Empfindlichkeit und die Beschränkung auf Bestrahlungswellenlängen im tiefen UV-Licht.

Ein Polysiloxan, das Disilan-Einheiten enthält, wird von M. Ishikawa et al. in J. Polym. Sci. 21, S. 657 (1983) beschrieben. Neben der bekannten niedrigen Glastemperatur von Si-O-Si-Gruppen enthaltenden Polymeren kommt im Falle dieser Verbindung noch eine aufwendige Synthese der zu diesen Verbindungen notwendigen siliciumhaltigen Monomeren hinzu. Untersuchungen zur Photolyse von siloxangruppenhaltigen Verbindungen werden von M. Ishikawa in "Polym. Prepr. ACS", Polymer Chem. 28, 426 (1987) vorgestellt.

Weiterhin sind Polymere mit Polysilangruppen als Bestandteil der Hauptkette bekannt, die zwei bis sechs miteinander verbundene Si-Atome enthalten (EP-A-0 129 834, JP-A-153931/1983, JP-A-061831/1984, JP-A-008839/1985, JP-A-118745/1986, JP-A-189533/1986 und JP-A-025744/1987). Verbindungen dieser Art sind zwar gegenüber dem reaktiven Sauerstoff-Ionenätzen resistent, sie sind aber gleichzeitig gegenüber tiefem UV-Licht als Chromophor wirksam, d.h. durch Licht dieser Wellenlängen spaltbar. Darin liegt auch ihr Nachteil für die Anwendung in lichtempfindlichen Mischungen: Die Bestrahlungswellenlängen sind auf den tiefen UV-Bereich beschränkt und damit bei den heutigen zur Massenproduktion benutzten I- und H-line Belichtungsgeräten nicht anwendbar. Ein weiterer Nachteil liegt in der Schwierigkeit der Synthese dieser Verbindungen, weil Alkalimetalle in hochreaktiver Form verwendet werden müssen. Gleichzeitig ist nicht ohne weiteres gewährleistet, daß Polymere entstehen, die in wäßrigem Alkali löslich sind. Dies würde eine Lösemittelentwicklung nach sich ziehen, was aber gemäß den Auflagen des Umweltschutzes nicht in Betracht zu ziehen ist. Zudem ist ihre Verträglichkeit mit Kresol-Formaldehyd-Novolak-Harzen nicht gegeben, da Mischungen dieser Komponenten sich sofort entmischen, bevor sich ein gleichmäßiger Film auf den Träger (Substrat) bzw. auf der Planarisierungsschicht ausbilden kann.

Bindemittel für lichtempfindliche Mischungen, die Monosilangruppen ($-SiR_3$) enthalten, werden in EP-A-0 096 596 beschrieben. Nachteile der Verbindungen dieses Typs sind u.a. eine komplizierte Monomer- und auch Polymersynthese. Durch Einführung nur eines Silicium-Atoms pro Monomer-Einheit wird der minimal für eine entsprechende Plasmaätzbeständigkeit zu fordernde Siliciumgehalt der Bindemitteln, wenn überhaupt, nur sehr schwer erreicht werden können. Ein gravierender Nachteil ist, daß diese Bindemittel lediglich eine Bilddifferenzierung aufgrund einer Entwicklung mit organischen Lösemitteln zulassen.

Die DE-A-22 17 744 beschreibt polymere Bindemittel, ebenso mit $-SiR_3$-Gruppen, hier aber entstanden durch eine polymeranaloge Umsetzung von polymeren Bindemitteln mit reaktiven siliciumhaltigen Verbindungen oder durch Copolymerisation. Ob diese Verbindungen plasmaätzbeständig sind, ist dieser Schrift nicht zu entnehmen, sie sollen eine Verbesserung der Haftung auf Substraten herbeiführen. Nachweislich ist aber wegen der chemischen Reaktionsfähigkeit von Si-X-Bindungen die Lagerfähigkeit dieser Verbindungen sehr begrenzt, u.U. ist eine Nachvernetzung möglich.

Methylenverbrückte Si-Fragmente tragende Bindemittel werden als Bestandteil von Resistsystemen in JP-A-177005/1987 beschrieben. Die Verbindungen dieses Typs sind aber nur über eine mehrstufige und aufwendige Synthese herstellbar.

Si-haltige Bindemittel, bei denen die phenolischen Hydroxylfunktionen über Ester- bzw. Iminoester-Funktionen mit Silicium verknüpft sind, werden in der JP-A-264342/1986 beschrieben. Ein Nachteil ist aber, daß die beschriebenen Silicium-Ester bzw. Silicium-Iminoester-Einheiten bei der zur Photolyse der zugesetzten Naphthochinondiazide bzw. Benzochinondiazide verwendeten Wellenlängen ebenfalls zersetzlich sind und abgespalten werden. Ein weiterer Nachteil der angeführten Verbindungen ist deren chemische Labilität gegenüber beispielsweise hydrolytischer Zersetzung, was sich ungünstig auf die Lagerstabilität auswirkt. Weiterhin nachteilig ist die schwierig reproduzierbare und mit niedrigen Gesamtausbeuten ablaufende mehrstufige Synthese der angeführten Verbindungen.

Bindemittel, denen Monomere, die Disilanyl-Einheiten enthalten, zugemischt werden, um dem betreffenden Wirtspolymeren Plasmatzbeständigkeit zu verleihen, werden in den US-A-4,481,279 und 4,464,455, sowie ähnliche Verbindungen in der JP-A-125729/1984, 125730/1984 und 121042/1984 beschrieben. Die dem Bindemittel zugemischten Disilanylverbindungen werden durch ionisierende Strahlung in der Polymermatrix verankert. Vor dem Entwicklungsschritt durch das reaktive Ionenätzen mit Sauerstoff wird das Disilan aus dem nichtbelichteten Bereich beispielsweise mit Hilfe eines Vakuumverfahrens entfernt. Die Nachteile des Verfahrens sind u.a., daß die bildmäßige Differenzierung unbefriedigend ist, weil in den unbelichteten Bereichen noch siliciumhaltige Monomere vorhanden sind und diese auch durch das obengenannte Vakuumverfahren nur ungenügend entfernt werden können.

Polymere mit wiederkehrenden Disilanyleinheiten, gebunden an Alkylen und Arylen über Alkinylengruppen, werden in den JP-A-152 892/1982 und JP-A-034 923/1987 beschrieben. Nachteile der Verbindungen diesen Typs sind ein kompliziertes Herstellungsverfahren der Bindemittel, sowie die chemische Labilität der in den Verbindungen enthaltenen $-Si-C{\equiv}C-$ Bindungen. U.U. wird eine Selbstentwicklung von lichtempfindlichen Systemen, die diese Bindemittel enthalten, beobachtet.

$\alpha$-Methylenstyrolpolymere, die in para-Stellung eine über eine Disilanylgruppe gebundene Propenylgruppe enthält, werden in der JP-A-256 804/1987 beschrieben. Unter Zusatz von Polymerisationsinitiatoren können die vorliegenden Verbindungen als negativ arbeitende lichtempfindliche Systeme verwendet werden, wobei die Styrolpolymere unter Lichteinwirkung über die ungesättigten Gruppen vernetzen. Die letztendlich entstehenden Polymere tragen die Disilanyleinheiten nicht mehr als Seitengruppen, sondern die Disilanyleinheiten sind Bestandteile der Polymerkette selbst.

Es bestand daher die Aufgabe, ein Bindemittel bereitzustellen, das in wäßrigem Alkali löslich, zumindest aber quellbar ist, als Bestandteile eines lichtempfindlichen Gemisches diesem eine ausreichende Plasmaätzbeständigkeit gegenüber reaktivem Ionenätzen, insbesondere mit Sauerstoff ermöglicht, dem Gemisch eine hohe Lagerbeständigkeit gewährleistet, d.h. weder hydrolytisch noch sonst chemisch nicht abbaubar ist, sowie die Voraussetzung einer Belichtung mit den heutigen Belichtungsgeräten möglich macht, ohne einen durch diese Strahlung ausgelösten Abbau des Polymeren einzuleiten, sowie eine hohe Wärmestabilität aufweist.

Gelöst wird die Aufgabe durch in wäßrigem Alkali lösliche, zumindest quellbare, polymere Bindemittel mit seitenständigen aliphatischen und/oder aromatischen Hydroxylgruppen. Die Bindemittel sind an den Hydroxylgruppen modifiziert durch Umsetzung mit einem Silicium enthaltenden Reagens der allgemeinen Formel I

$$(A - B_n -)_m C \qquad (I)$$

oder durch Umsetzung mit einem Pfropfungsreagens der allgemeinen Formel II

$(D\ -)_o(E\ -)_p\ B\ -\ C$ (II),

das seinerseits Hydroxylgruppen enthält, und dem Silicium enthaltenden Reagens der allgemeinen Formel I, worin

A eine Silanylgruppe mit mindestens 2 miteinander verknüpften Siliciumatomen insgesamt, aber nicht mehr als 3 miteinander verknüpften Siliciumatomen in einer unverzweigten Kette aus Siliciumatomen,

B eine Brückengruppe der allgemeinen Formel IV

$-(b_1)r\ -\ (X)\ -\ (b_2)_s-$ (IV)

worin

$b_1$ $(C_1\text{-}C_4)$Alkylen - insbesondere $C_2$-Alkylen - ist oder eine aus einem Alkdienylen, insbesondere einem Cycloalkdienylen mit insgesamt mindestens 4 C-Atomen, bevorzugt Cyclopentadienyl, mit einem Dienophil in einer 1,4-Cycloaddition (Diels-Alder-Reaktion) entstehende Gruppe, die mindestens eine C-C-Doppelbindung aufweist,

X eine Einfachbindung, -O-, -S-, $-SO_2-$, -NH-, $-NR^1-$, -O-CO-, -NH-CO- oder -NH-CO-O-, worin $R^1$ ein $(C_1\text{-}C_3)$Alkyl ist, und

$b_2$ Arylen, insbesondere Naphthylen und Phenylen, gegebenenfalls substituiert durch $(C_1\text{-}C_3)$-Alkyl, $(C_1\text{-}C_3)$Alkoxy, insbesondere durch Methyl und in ortho-Position zu der Bindung, die die funktionelle Gruppe trägt, oder Cycloalkylen, insbesondere Cyclohexylen, ist, sowie

r,s unabhängig voneinander 0 oder 1 sind,

C eine funktionelle Gruppe, insbesondere eine Epoxygruppe, die gegebenenfalls über eine Alkylen- oder Oxaethanogruppe gebunden ist, eine Aziridino- und Carboxylgruppe oder deren Derivat, wie Ester, Carbonsäurechlorid, Carbonsäureamid, Anhydrid, Lacton und Lactam, aber auch eine Isocyanat- und Carbodiimidgruppe, die mit den Hydroxylgruppen des Bindemittels und/oder der Gruppen D und/oder E unter Ausbildung einer kovalenten Bindung reagieren kann,

D der Rest eines ein- oder mehrwertigen aliphatischen bzw. cycloaliphatischen Alkohols, der gegebenenfalls über mindestens eine Hydroxylgruppe eine Bindung zur Gruppe C der Funktionseinheit $[(A\ -\ B_n\ -)_m\ C]$ ausbilden kann, und

E der Rest eines ein- oder mehrwertigen aromatischen Alkohols, der gegebenenfalls über mindestens eine Hydroxylgruppe eine Bindung zur Gruppe C der Funktionseinheit $[(A\ -\ B_n\ -)_m\ C]$ ausbilden kann, sowie

m 1 oder 2 und

n, o und p unabhängig voneinander 0 oder 1 bedeuten

und weisen einen Siliciumgehalt von 7 bis 30 Gew.-% auf.

Das Reagens der allgemeinen Formel I beinhaltet die eigentlichen Silanylgruppen. Es ist entweder direkt oder über die Pfropfungsgruppen an die aliphatischen bzw. aromatischen Hydroxylgruppen des polymeren Bindemittels gebunden.

Die erfindungsgemäßen modifizierten Bindemittel sind gegenüber Strahlung einer Wellenlänge von größer als 300 nm beständig.

Als Gruppen A werden Silanylgruppen der allgemeinen Formel III

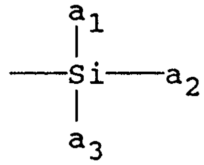

(III)

genannt, worin

$a_1$-$a_3$ R, $-SiR_3$ und $-Si_2R_5$ sind, wobei R für $(C_1\text{-}C_3)$Alkyl, insbesondere Methyl, und/oder Aryl, insbesondere Phenyl, steht, mit der Maßgabe, daß mindestens einer der Reste $a_1$ bis $a_3$ $-SiR_3$

und nicht mehr als einer dieser Reste $-Si_2R_5$ ist.

Besonders bevorzugt sind $-SiR(SiR_3)_2$, $-SiR(SiR_3)_3$ und $-SiR(SiR_2)_2-SiR_3$.

Wenn in der Brückengruppe B s = 1 und X eine Einfachbindung darstellt, ist $b_1$ eine Alkylengruppe mit 2 oder mehr C-Atomen, insbesondere eine $C_2$-Alkylengruppe. Bevorzugt ist $b_1$ an Gruppe A gebunden.

Von den funktionellen Gruppen C sind diejenigen bevorzugt, die in einer Reaktion mit Hydroxylgruppen der Bindemittel durch Addition reagieren und von diesen wiederum diejenigen, bei denen sich während der Additionsreaktion keine Aminogruppen bilden.

Fast alle funktionellen Gruppen C sind monovalent, d.h. die Gruppen A und B bzw. D und E sind einmal in einer seitenständigen Silanylgruppe der allgemeinen Formel I enthalten (m = 1 und n = 1). Ist m = 2 und n = 1, handelt es sich bei dieser, den Gruppen A und B benachbarten, Gruppe C um eine bivalente funktionelle Gruppe C, z.B. um ein Carbodiimid.

Insbesondere wenn Lactone oder Lactame als funktionelle Gruppen C verwendet werden, gilt n = 0 (m = 1). Von den Lactonen und Lactamen sind die $\beta$-Lactone bzw. -Lactame, die $\delta$-Lactone bzw. -Lactame und die $\gamma$-Lactone bzw. -Lactame bevorzugt. Insbesondere werden die entsprechenden Lactone bevorzugt.

Von den Anhydriden werden insbesondere cyclische Anhydride bevorzugt, da diese im Gegensatz zu den offenkettigen Verbindungen nach einem Additionsschema reagieren. Ganz besonders bevorzugt ist die Maleinsäureanhydridgruppe. Die Anhydride können weiterhin ggf., sofern sie ein Dienophil sind, in einer 1,4-Cycloaddition (Diels-Alder-Reaktion) über eine entsprechende Brückengruppe B mit der Silanylgruppe A verbunden werden. Die Anhydridgruppe kann aber auch mit einem zur Cycloaddition befähigten Dienfragment verbunden sein.

Von den bevorzugtes funktionellen Gruppen C ist weiterhin die über eine Oxaalkylengruppe gebundene Epoxygruppe zu nennen, die sowohl über $b_1$, sofern s = 0 ist und X entweder eine weniger bevorzugte Einfachbindung oder eine

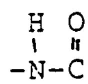 -Gruppe

ist, als auch über $b_2$, sofern s = 1, X bevorzugt eine Einfachbindung und $b_2$ Phenylen ist, mit der Silanylgruppe verbunden ist.

Auch die Isocyanat-Gruppe ist bevorzugt. Sie ist besonders bevorzugt mit $b_1$, sofern s = 0, als auch mit $b_2$, sofern

X = 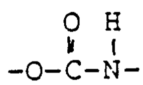

ist, verbunden.

Die ebenso als funktionelle Gruppen C genannten Carbodiimide gelten für m = 2 und n = 1, und nur als der Funktionseinheit $(A\text{-}B_n)_m$ benachbarten Gruppen. Diese werden durch Reaktion von zwei Isocyanatgruppen miteinander unter Abspaltung von $CO_2$ gewonnen. Infolgedessen gelten alle Anmerkungen, die über die Isocyanatgruppen gemacht werden, auch für die Carbodiimidgruppen, die bevorzugt über Brückenglied $b_1$, sofern s = 0 ist und X eine Einfachbindung darstellt, an die Silanylgruppe gebunden sind.

Grundsätzlich sind aber Silylierungsreagenzen, die Isocyanatgruppen aufweisen, denjenigen, die Carbodiimidgruppen enthalten, vorzuziehen, da erstere gegenüber thermischer Belastung und chemischem Angriff beständigere Produkte ergeben.

Die Herstellung von Verbindungen, die Isocyanatgruppen enthalten, wird von S. Patai, The Chemistry of Cyanates and their Thio Derivatives, Part 2, Seite 619 ff beschrieben. Dort werden auch die funktionellen Gruppen beschrieben, die grundsätzlich in der Lage sind, mit dieser Gruppe zu reagieren, insbesondere in eine Additionsreaktion einzutreten.

Weiterhin sind dem Fachmann eine Vielzahl von funktionellen Gruppen bekannt, die eine kovalente Verknüpfung zwischen Silylierungsreagenz und Bindemittel ermöglichen. Solche Gruppen werden beispielsweise von H.A. Staab in Angew. Chem. 74, 407 (1962) beschrieben.

Darüber hinaus sind als funktionelle Gruppen auch solche geeignet, die z.B. in der Peptid-Chemie zur Bindungsbildung angewandt werden und u.a. beispielsweise von K. Takeda, K. Tsuboyama, K. Yamaguchi und H. Ogura in J. Org. Chem. 50, 273 (1985) oder von T. Mukaiyama, M. Usui, E. Shimada und K. Saigo in Chem. Lett. 741 (1975) beschrieben sind.

Bezüglich der Gruppen B und C innerhalb der Pfropfungsgruppe und Funktionseinheit $(D_oE_p)BC$ lassen sich folgende bevorzugte Ausgestaltungen vornehmen:

Die Gruppe B weist gemäß Formel IV in diesem Fall bevorzugt (für r und s jeweils gleich 1) als

$b_1$ $C_2$-Alkylen,

$b_2$ Phenylen, insbesondere in ortho-Position zu der Bindung, die die funktionelle Gruppe trägt, durch Methyl substituiert und für

X eine Einfachbindung,

$$-O-,\ -O-\overset{O}{\overset{\|}{C}}-\overset{H}{\overset{|}{N}}-\ \text{auf.}$$

Besonders geeignet sind auch diejenigen Gruppen B innerhalb der genannten Funktionseinheit, in denen

r und s jeweils gleich 0 ist und

X eine Einfachbindung darstellt.

Ebenso bevorzugt ist der Fall, wenn

r 0 und

s 1 ist, wobei

X

$$-O-\ \text{oder}\ -O-\overset{O}{\overset{\|}{C}}-\overset{H}{\overset{|}{N}}\ \text{ist.}$$

Die Gruppen D leiten sich ab von mehrwertigen, insbesondere zwei- bis sechswertigen aliphatischen Alkoholen, wozu 1,2-Glykol, Propan-1,2,3-triol, Erytrite, Pentite und Hexite zählen. Von einwertigen Alkoholen abgeleitete Gruppen, wie die Hydroxymethylgruppe, sind über eine C-C-Einfachbindung direkt bzw. über die Brückengruppe B an die funktionelle Gruppe C dieser Funktionseinheit gebunden.

Die mehrwertigen Alkohole können mit weiteren aliphatischen Alkoholen verethert sein. Diese Alkohole haben bevorzugt die gleiche Wertigkeit wie die Alkohole, die mit diesen verethert sind. Bevorzugt sind die nicht vollständig veretherten Produkte, besonders die aus Propan-1,2,3-triol gebildeten Ether. Die in diesem Fall nicht veretherte Hydroxylgruppe des ursprünglich zur Veretherung eingesetzten Alkohols trägt vorzugsweise entweder die Gruppe E ($p = 1$) oder für $p = 0$ die Brückengruppe B, sofern die Summe aus r und s ungleich Null ist. Ansonsten (r und s gleich Null und X eine Einfachbindung) wäre die aliphatische Pfropfungsgruppe D direkt verbrükkende Gruppe zwischen der funktionellen Gruppe C der Funktionseinheit $(A\text{-}B_n\text{-})_mC$ und der funktionellen Gruppe C der Pfropfungsgruppe und Funktionseinheit $(D\text{-})_o(E\text{-})_pB\text{-}C$. In diesem Falle wird zur Bindung der funktionellen Gruppe C der Funktionseinheit $[(A\text{-}B_n\text{-})_mC]$ wiederum eine Hydroxylgruppe von Gruppe D benötigt. Wenn die aufgepfropfte Gruppe nicht mit dem Silylierungsreagens umgesetzt ist, verfügt der Rest des mehrwertigen aliphatischen Alkohols, sofern er mit dem in der silylierten Pfropfungsgruppe identisch ist, über eine Hydroxylgruppe mehr, da diese Hydroxylgruppe nicht mehr verethert sein muß zur Bindung des Silylierungsreagenzes.

Für den speziellen Fall, daß in der Brückengruppe B der Pfropfungsgruppe die Summe aus r und s = 0 ist und X eine Einfachbindung darstellt, kann bei Verwendung insbesondere einer Epoxygruppe als Gruppe C in dieser Funktionseinheit bei $p = 0$, der aliphatische Alkohol D einen einwertigen Alkohol darstellen. In diesem Fall handelt es sich z.B. um eine über eine Einfachbindung gebundene Hydroxymethylgruppe. Diese spezielle Ausgestaltung ist dann von Interesse, wenn das Polymere per se vorwiegend lediglich aromatische Hydroxylgruppen enthält, die es gilt, in u.U. reaktivere, aliphatische Hydroxylgruppen umzuwandeln. Insbesondere gilt diese Ausführung für Lactone als funktionelle Gruppen C.

Die Gruppen E leiten sich ab von mehrwertigen aromatischen Alkoholen (Phenolen). Die zwei- bis fünfwertigen aromatischen Alkohole von Benzol bzw. Naphthalin sind bevorzugt. Besonders bevorzugt sind die drei- bis fünfwertigen Alkohole und hierunter die dreiwertigen Alkohole des Benzols, wie Phloroglucin, Pyrogallol und Hydroxyhydrochinon, wobei Pyrogallol besonders geeignet ist. $n = 1$ gilt für einwertige Alkohole, die über eine C-C-Einfachbindung direkt bzw. über eine Brückengruppe B an die funktionelle Gruppe C dieser Funktionseinheit gebunden sind, insbesondere werden Hydroxylphenylengruppen genannt. Sofern $o = 1$ ist eine der genannten, in den Gruppen E enthaltenen Hydroxylgruppen, zur Ausbildung einer

Etherfunktion zur benachbarten Gruppe D notwendig, ansonsten ist diese Hydroxylgruppe Bindeglied zu der Funktionseinheit $[(A\text{-}B_n)_mC]$, oder liegt als freie Hydroxylgruppe vor. Eine weitere Hydroxylgruppe muß aber reserviert bleiben für die Bindungsbildung zur Brückengruppe B.

Speziell für Gruppen E ist die Brückengruppe B dieser Funktionseinheit insbesondere in der Weise ausgestaltet, daß

r 0 und

$b_2$ (s = 1) Phenylen oder ein in ortho-Position zu der Bindung, die die funktionelle Gruppe trägt, durch Methyl substituierter Phenylenrest ist.

Für den speziellen Fall, daß in dieser Brückengruppe B die Summe aus r und s gleich 0 ist und X eine Einfachbindung darstellt, ist bei Verwendung insbesondere der Epoxygruppen als Gruppe C der aromatische Alkohol E (o = 0) bevorzugt einwertig, d.h. eine z.B. über eine Einfachbindung gebundene Hydroxyphenylengruppe. Dieser spezielle Fall ist dann anzutreffen, wenn das Polymere per se sehr hydrophil ist. Dies gilt insbeson dere für Naturstoffe wie die Tannine. Durch die Einführung von hydrophoben aromatischen Gruppen, ohne die Anzahl der Hydroxylgruppen gleichzeitig beträchtlich anzuheben, kann u.U. die Löslichkeit des Bindemittels in alkalihaltigen Entwicklerlösungsmitteln reguliert werden.

Besonders bevorzugt sind im allgemeinen auch die Kombinationen, in denen o + p = 1 ergibt.

Die Reihenfolge der Gruppen D und E im Molekül ist für den Fall o + p = 2 nicht von Bedeutung.

Da die Bindung der Brückengruppe B als Teil der Pfropfungseinheiten über die Hydroxylgruppen der Gruppen D und/oder E erfolgen muß, sind für diesen Fall die Brückengruppen B auf Gruppen zu beschränken, die in der Lage sind, mit Hydroxylgruppen zu reagieren. Insbesondere ist B in diesem Fall eine Gruppe der allgemeinen Formel IV, in der

r 0,

X eine Einfachbindung,

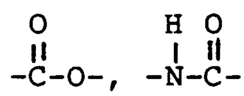 oder

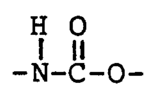 und

$b_2$ Phenylen, ggf. substituiert durch ($C_1$-$C_3$) Alkyl, insbesondere Methyl in ortho-Position zu der Bindung, die die funktionelle Gruppe C trägt,

bedeuten.

Die Einführung der Gruppen D und/oder E in die Pfropfungseinheiten dient zur Modifizierung bzw. zur Aufrechterhaltung der Alkalilöslichkeit des silylierten Bindemittels, denn bei der unmittelbaren Silylierung des sowohl aromatische wie aliphatische Hydroxylgruppen aufweisenden Bindemittels geht je nach Ausmaß der Silylierungsreaktion eine mehr oder weniger große Anzahl von freien Hydroxylgruppen, die für die Alkalilöslichkeit notwendig sind, verloren. Dies gilt auch für die Hydroxylgruppen der Pfropfungsgruppen, sofern diese schon vorher in das Bindemittel eingeführt worden sind.

Ohne Zweifel kann durch die Einführung der Silanylgruppen in die Seitenketten des Bindemittels die Alkalilöslichkeit im Grenzbereich, d.h. bei sehr hohem Siliciumgehalt des Bindemittels, beeinträchtigt sein.

Um dennoch die Alkalilöslichkeit zu gewährleisten, können sowohl vor der Silylierungsreaktion, als auch nach dieser Reaktion die Pfropfungsgruppen über die freien Hydroxylgruppen eingeführt werden. Sofern nicht silylierte Pfropfungsgruppen als Seitenketten des Bindemittels vorliegen, ist die Silylierungsreaktion bevorzugt vor der eigentlichen Pfropfungsreaktion durchgeführt worden. Der Fall tritt insbesondere auch dann häufig auf, wenn lediglich aromatisch gebundene Hydroxylgruppen durch die Pfropfungsreaktion eingeführt worden sind und die ursprünglich im Polymeren enthaltenen Hydroxylgruppen bevorzugt aliphatischer Natur sind. Dies gilt auch dann, wenn die Pfropfungsreaktion vor der Silylierungsreaktion durchgeführt worden ist.

Andererseits läßt sich, insbesondere wenn am Bindemittel selbst vorzugsweise aromatische Hydroxylgruppen für die Silylierungsreaktionen zur Verfügung stehen, durch Einführung von Pfropfungsgruppen, die aliphatische Hydroxylgruppen enthalten (p = 0), die Reaktivität des Polymeren für Silylierungsreagenzien

erhöhen, so daß bevorzugt keine "freien" Pfropfungsgruppen existieren, wenn auch die Pfropfungsgruppe silyliert wurde. Wenn im Gegensatz dazu aromatische Hydroxylgruppen an den Pfropfungsgruppen vorhanden sind, können auch in dem Falle, wenn erst nach der Einführung der Pfropfungsgruppe silyliert worden ist, vermehrt freie Pfropfungsgruppen vorliegen. Tritt der Fall ein, daß das Bindemittel zwar infolge seines hohen Siliciumgehalts eine hohe Plasmabeständigkeit aufweist, aber andererseits seine Alkalilöslichkeit gefährdet sein sollte, so kann ggf. auch nach erfolgter Pfropfung und anschließend vollständig ablaufender Silylierung (in Bezug auf die Hydroxylgruppen des Pfropfungsreagenzes) wiederum gepfropft werden.

Die Pfropfungsgruppen können nicht nur in diesem speziellen Fall verschieden sein, es können auch die silylierten und die nicht silylierten Pfropfungsgruppen jeweils verschieden ausgestaltet sein.

Je nach Reaktivität der zur Verfügung stehenden Hydroxylgruppen des Polymeren, können daher durch Wahl geeigneter Silylierungsreaktionen und der Reihenfolge ihrer Umsetzung mit den Polymeren, Bindemittel mit je nach den gestellten Anforderungen optimaler Plasmaätzbeständigkeit und hinreichender Alkalilöslichkeit geschaffen werden.

Der Siliciumgehalt der erfindungsgemäßen Bindemittel liegt bevorzugt im Bereich von 8 bis 20 Gew.-%, besonders bevorzugt von 9 bis 14 Gew.-%.

Die Bindemittel als solche müssen, um mit den funktionellen Gruppen C reagieren zu können, entweder aromatische und/oder aliphatische Hydroxylgruppen aufweisen. Von den aromatischen Hydroxylgruppen enthaltenden Bindemitteln sind insbesondere solche mit phenolischen Hydroxylgruppen zu nennen, bei denen die ihnen zugrunde liegenden Phenoleinheiten in die Polymerkette einkondensiert sind (z.B. Novolake, Pyrogallolharze), oder bei denen wie beim Polyvinylphenol, die Phenoleinheiten seitlich von der Polymerkette wegstehen, wie es auch in den folgenden Fällen ist, bei denen die Phenoleinheiten entweder esterartig an eine polymere Säure (z.B. Polymethacrylsäure) gebunden sind, oder z.B. als 4-Hydroxybenzaldehyd acetalartig gebunden in einem Polyvinylacetal vorliegen. Aliphatische Hydroxylgruppen liegen z.B. in Polyvinylalkoholen und mit mehrwertigen Alkoholen aliphatischer Natur veresterten Produkten dieser Polymerklasse vor, einschließlich der Copolymere.

Geeignete Hydroxylgruppen enthaltende Polymere sind z.B. Bindemittel vom Novolak-Typ. Genannt werden insbesondere Phenol-Formaldehydharze, Kresol-Formaldehydharze, deren Mischkondensate und deren Mischungen sowie Phenol- und Kresolkondensate mit Carbonylverbindungen, insbesondere mit Formaldehyd. Hierunter fallen auch die speziellen Novolak-Harze, die aus Gemischen aus m-/p-Kresol (DE-A-36 26 582) bzw. m-/p-Kresole und m-/p- und o-Kresolen bestehen (EP-A-0 070 624). Ebenso mitumfaßt sind Novolak-Harze, die aus Gemischen von m-/p-Kresolen und Xylenolen durch Kondensation mit Aldehyden hergestellt wurden (JP-A-16 4740/1985). Auch Novolak-Harze höheren Molekulargewichts sind umfaßt, insbesondere diejenigen, die aus Gemischen aus monoalkylierten Alkylphenolen hergestellt sind und deren Alkylgruppen in m- oder p-Stellung zu den phenolischen Hydroxylgruppen stehen. Aber auch reine Kresol-Formaldehyd-Harze, wie in der JP-A-57339/1985 beschrieben, sind möglich. Ebenso die Kombination reiner m-Kresol-Harze mit Alkylphenolen (EP-A-0 239 423). Insbesondere werden die Novolak-Harze aus den DE-A 38 10 631 und 38 10 632 verwendet.

Die erfindungsgemäß einzusetzenden Novolak-Harze weisen einen Schmelzbereich, der bei 105° C beginnt, auf. Bei Novolakharzen, deren Schmelzbereich sich von 105 bis 120° C erstreckt, liegt die Glastemperatur (Tg) im allgemeinen unter 100° C. Besonders bevorzugt für die vorliegende Erfindung sind jedoch Novolak-Harze, deren Glastemperatur mindestens 110° C, insbesondere mindestens 115° C ist.

Die genannten Bindemittel weisen einen RMW-Wert (reduziertes mittleres Molekulargewicht) von 10 bis 40, insbesondere von 15 bis 30 auf.

Die Ermittlung des RMW-Wertes wird in den DE-A 38 10 631 und 38 10 632 beschrieben.

Bevorzugt sind die Bindemittel, die aus einem Gemisch, das mindestens zu 50 Mol-% ein in meta-Position substituiertes Phenol enthält, entstehen, wobei als Substituenten $(C_1\text{-}C_3)$Alkyl, insbesondere Methyl, in Frage kommen. Hierunter wiederum sind insbesondere die Bindemittel zu nennen, deren Gemische zur Herstellung

a) mindestens zu 60 Mol-% ein in meta-Position substituiertes Phenol enthalten und bis zu 40 Mol-% ein tri- oder bireaktives Phenol der allgemeinen Formel I

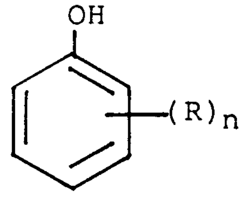

(I)

aufweisen, worin

R $(C_1$-$C_4)$Alkyl, insbesondere Methyl, Ethyl und/oder t-Butyl und

n eine ganze Zahl von 1 bis 3, insbesondere 2 oder 3

bedeuten, oder

b) mindestens zu 70 Mol-% das in meta-Position substituierte Phenol enthalten und bis zu 30 Mol-% ein monoreaktives Phenol der allgemeinen Formel II

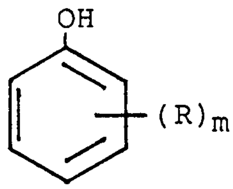

(II)

aufweisen, worin

R $(C_1$-$C_4)$Alkyl, insbesondere Methyl, Ethyl und/oder t-Butyl und

m eine ganze Zahl von 2 bis 4, insbesondere 3

bedeuten.

Insbesondere bevorzugt werden Bindemittel, deren Gemische zur Herstellung bis zu 30 Mol-%, besonders bevorzugt bis zu 20 Mol-%, ein tri- oder bireaktives Phenol der allgemeinen Formel I enthalten oder solche, die bis zu 15 Mol-%, besonders bevorzugt bis zu 10 Mol-%, ein monoreaktives Phenol der allgemeinen Formel II enthalten. Zu den trireaktiven Phenolen zählen solche, die in den Positionen 3, 5 oder 3 und 5 durch R substituiert sind. Die bireaktiven Phenole weisen sich dadurch aus, daß sie in den Positionen 2 oder 4, den Positionen 2 und 3, 3 und 4, 2 und 5 oder in den Positionen 2,3 und 5 sowie 3,4 und 5 substituiert sind. Monoreaktive Phenole zeichnen sich dadurch aus, daß sie Substituenten in den Positionen 2 und 4 oder 2 und 6, 2,3 und 4, 2,3 und 6 sowie 2,4 und 5 oder 2,3,4 und 5 sowie 2,3,5 und 6 aufweisen.

Die in erfindungsgemäßer Weise zu verwendenden Novolak-Bindemittel können in gewissem Umfang mit Chloressigsäure, Isocyanaten, Epoxiden oder Carbonsäureanhydriden modifiziert sein (DE-A-27 18 254).

Ebenso werden hydroxygruppenhaltige Polymere vom Polyvinylphenol-Typ als für das erfindungsgemäße Bindemittel geeignet gesehen. Solche Polymere aus o-, m- und p-Vinylphenolen werden in der DE-A-23 22 230 und der DE-A-33 09 222 beschrieben. Derivate werden in der DE-A-34 06 927 genannt.

Daneben sind Copolymere aus Vinylphenol mit Komponenten mit aliphatischen Hydroxylgruppen zu nennen, z.B. Hydroxyethyl(meth)acrylat.

Ebenso kommen hydroxygruppenhaltige Bindemittel in Frage, die Copolymere von Maleinsäureanhydrid und Styrol, von Vinylacetat und Crotonsäure, von Alkylmethacrylat, Butadien und Methacrylsäure darstellen (DE-A-31 07 526).

Daneben können auch Hydrochinon- und Dihydroxynaphthalinmonomethacrylate eingesetzt werden (JP-A-36129/1976).

Abkömmlinge der (Meth)acrylsäure, die in der Seitenkette Brenzcatechin- oder Pyrogallol-Einheiten enthalten, werden auch in den DE-A-35 28 929 und DE-A-35 28 930 beschrieben und sind daher für die vorliegende Verwendung besonders geeignet. Bindemittel, die (Meth)acrylsäure/Alkyl(meth)acrylat-Mischpolymerisate darstellen, werden in der DE-A-37 30 881 genannt.

Bindemittel, geeignet für lichtempfindliche Gemische, die auf hydroxylgruppenhaltigen Polymeren basieren und mit Säureanhydriden umgesetzt worden sind, sind aus der EP-A-0 152 819 bekannt. Ebenso wie diese sind auch die modifizierten Polyvinylacetale aus den DE-A-36 44 162 und DE-A-36 44 163 zur Herstellung der erfindungsgemäßen Bindemittel geeignet.

In wäßrigem Alkali lösliche bzw. zumindest quellbare Bindemittel für lichtempfindliche Gemische, die seiten ständige Gruppen der Formel $-CH_2OR$ enthalten, worin R Wasserstoff, niedere Alkyl-, Acyl- oder Hydroxyalkylgruppen bedeuten können, werden in der DE-A-34 42 756 sowie der DE-A-33 29 443 genannt. Diese Bindemittel, sofern sie eine hinreichende Anzahl von freien Hydroxylgruppen enthalten, werden als Ausgangsmaterialien für die erfindungsgemäßen Bindemittel verwendet.

Ebenso werden in Alkali lösliche bzw. zumindest quellbare Bindemittel vom Pyrogallol-Typ für die Herstelung der erfindungsgemäßen Bindemittel verwendet. Diese enthalten als Bestandteile der Polymerkette Trihydroxyphenoleinheiten. Für die Umsetzung mit Silylierungsreagenzien zur Gewinnung der erfindungsgemäßen Bindemittel stehen daher drei aromatische Hydroxylgruppen zur Verfügung (US-A-3,635,709).

Aber auch Polymere, die 3,4,5-Trihydroxyphenolcarbonsäure-Einheiten enthalten (Gallussäure), sind als Ausgangspolymere für die Herstellung der erfindungsgemäßen Bindemittel geeignet. Insbesondere sind die natürlichen Gerbsäuren (Tannine) zu nennen. In diesen sind die Hydroxylfunktionen von Glucoseeinheiten mit den Gallussäuren in unterschiedlichem Maße verestert. Z.B. ist die β-Penta-O-galloyl-D-glucose geeignet. Es ist aber auch möglich, daß jede Hydroxylfunktion der Glucoseeinheiten nicht nur mit jeweils einem Gallussäuremolekül verestert ist, es können auch sogenannte Depside aus zwei Molekülen Gallussäuren ( = m-Galloyl-gallussäure) jeweils als Einheit mit einer Hydroxylfunktion der Glucose reagieren. Es entstehen dann β-Penta-O-digalloyl-D-glucosen. Die natürlichen Tannine, enthaltend Gallussäuren, werden von E.Haslam in Fortschritte der Chem. Org. Naturst. 41, Seite 1 ff (1982) beschrieben.

Die erfindungsgemäß beanspruchten Bindemittel sind gegenüber UV-Strahlung beständig, insbesondere im Bereich einer Wellenlänge größer als 300 nm.

Bevorzugte Silylierungsreagenzien sind in der DE-A 38 11 241 genannt. Dort wird auch ihre Darstellung beschrieben.

Insbesondere genannt werden:
2-(Pentaalkyl- bzw. -aryl-disilanyl)-($C_1$-$C_4$)alkylisocyanate, 2-[Tris(trialkyl- bzw. -aryl-silyl)silanyl]-($C_1$-$C_4$)-alkylisocyanate, 2-[Bis(trialkyl- bzw. -arylsilyl)silanylalkyl]-($C_1$-$C_4$)alkylisocyanate sowie 2-(Heptaalkyl- bzw. -aryl-trisilanyl)-($C_1$-$C_4$)alkylisocyanate. Unter den Vertretern dieser Monomere sind solche besonders bevorzugt, deren Silanylrest Alkylgruppen trägt, insbesondere Methyl. Als Bindeglied wird besonders bevorzugt in diesen Verbindungen die Ethylengruppe eingesetzt.

Bevorzugte Vertreter derjenigen Verbindungen, die als funktionelle Gruppen Epoxygruppen enthalten, sind:
4-(ω-Pentaalkyl- bzw. -aryl-disilanyl-($C_1$-$C_4$)alkyl)-O-2,3-epoxypropyl-phenole, 4-[ω-Tris(trialkyl- bzw. -aryl-silyl)silanyl-($C_1$-$C_4$)alkyl]-O-2,3-epoxypropylphenole, 4-[ω-Bis(trialkylsilyl)silanylalkyl-($C_1$-$C_4$)alkyl]-O-2,3-expoxypropyl-phenole sowie 4-(ω-Heptaalkyltrisilanyl-($C_1$-$C_4$)alkyl)-O-2,3-expoxy-propyl-phenole. Genannt werden auch die entsprechenden Verbindungen, deren Silanylrest sich in Position 2 zu der O-2,3-Epoxpropylgruppe befindet. Der ($C_1$-$C_4$)Alkylrest, über den der Silanylrest sowohl in Position 2 wie auch bevorzugt in Position 4 gebunden ist, ist besonders bevorzugt mindestens ein $C_2$-Alkylrest, wobei $C_2$-Alkyl auch der bevorzugte Rest dieser Reihe darstellt. Der Silanylrest ist dann in Position 2 des $C_2$-Alkylrestes gebunden. Besonders bevorzugt sind bei dieser Verbindungsklasse auch diejenigen Verbindungen, bei denen die Alkylgruppen im jeweiligen Silanylrest vorhanden sind und insbesondere Methyl entsprechen. Die aromatische Einheit in der Brückengruppe der hier beschriebenen Verbindungen kann auch substituiert sein durch Alkyl und Alkoxy. Bevorzugt ist diese Ausführungsform aber nicht.

Bevorzugte Vertreter von Diels-Alder-Produkten sind:
(2,3)-endo-7-anti-Pentaalkyl- bzw. -aryl-disilanyl-bicyclo[2.2.1]hept-5-en-2,3-dicarbonsäureanhydrid, (2,3)-endo-7-anti-Tris(trialkyl- bzw. -aryl-silyl)silanyl-bicyclo[2.2.1]hept-5-en-2,3-dicarbonsäureanhydrid, (2,3)-endo-7-anti-Bis(trialkyl- bzw. -aryl-silyl)-silanylalkyl-bicyclo [2.2.1]hept-5-en-2,3-dicarbon-säureanhydrid, (2,3)-endo-7-anti-Heptaalkyl- bzw. -aryltrisilanyl-bicyclo [2.2.1]hept-5-en-2,3-dicarbonsäureanhydrid. Besonders bevorzugt sind Verbindungen, bei denen Alkylgruppen in dem jeweiligen Silanylrest vorhanden sind und Methyl darstellen.

Von den Lactamen bzw. Lactonen werden folgende Verbindungen bevorzugt:
3-Pentaalkyl- bzw. -aryl-disilanyl-lactone und -lactame, Tristrialkyl- bzw. -aryl-silylsilanyl-lactone und -lactame, Bis(trialkyl- bzw. -aryl-silyl)silanylalkyl-lactone und -lactame, sowie Heptaalkyltrisilanyl-lactone und -lactame. Besonders bevorzugt sind die Verbindungen, bei denen Alkylgruppen in den jeweiligen Silanylresten vorhanden sind und Methyl darstellen.

Lactone sind besonders bevorzugt, insbesondere β-Propiolactone, β- und γ-Butyrolactone, β-, γ- und δ-Valerolactone, γ- und δ-Caprolactone.

Von den Funktionseinheiten, die Carbodiimid als funktionelle Gruppe aufweisen, sind alle die Verbindungen zu nennen, die auch Isocyanatgruppen aufweisen können. Im Vergleich zu diesen sind aber die Verbindungen mit Carbodiimid weniger bevorzugt, da sie hydrolytisch instabiler sind.

Weiterhin sind Funktionseinheiten bevorzugt, deren Brückengruppe Carbaminsäureeinheiten als X enthalten. Die eigentlichen funktionellen Gruppen können an diesen Einheiten direkt esterartig gebunden sein, die Einheiten können aber auch als verbindendes Glied in der Brückengruppe fungieren, d.h. mit den funktionellen Gruppen nicht direkt verbunden sein.

Als Beispiele sind zu nennen:
N-ω-(Pentaalkyl- bzw. -aryl-disilanyl)-($C_1$-$C_4$)alkyl-O-2,3-epoxypropyl-carbaminsäuren, N-ω-[Tris(trialkyl-bzw. -aryl-silyl)silanyl]-($C_1$-$C_4$)alkyl-O-2,3-epoxypropylcarbaminsäuren, N-ω-[ Bis(trialkyl- bzw. aryl-silyl)-silanylalkyl]-($C_1$-$C_4$)alkyl-O-2,3-epoxypropylcarbaminsäuren, N-ω-(Heptaalkyl- bzw. -aryl-disilanyl)-($C_1$-$C_4$)-alkyl-O-2,3-epoxypropylcarbaminsäuren.

Von diesen wiederum sind diejenigen bevorzugt, die Alkylgruppen aufweisen und insbesondere Methyl bedeuten. Von den Brückeneinheiten $(C_1-C_4)$Alkylen sind wiederum die mit $C_2$-Alkylen bevorzugt, so daß die Position "ω" als Position 2 präzisiert werden kann. Neben diesen werden besonders bevorzugt:
N-Isocyatophenyl-O-(ω-silanyl)-$(C_1-C_4)$alkylcarbaminsäuren, wobei als Silanyl, wie in den vorherigen Beispielen jeweils Pentaalkyldisilanyl, Tris(trialkylsilyl)silanyl, Bis(trialkylsilyl)silanyl und Heptaalkyltrisilanyl sowie auch die entsprechenden Arylsilanyle zu verstehen sind.

Als $(C_1-C_4)$Alkylreste werden wiederum diejenigen mit $C_2$-Alkylen bevorzugt, so daß die Position "ω" als Position 2 präzisiert werden kann. Ganz besonders bevorzugt sind Verbindungen dieses Typs, die die Isocyanatgruppen in Position 4 des Phenylrestes tragen, worunter wiederum diejenigen besonders eingesetzt werden, deren Phenylrest zusätzlich in Position 3 durch Alkyl, insbesondere durch Methyl substituiert ist. Die Alkylsubstituenten der Silanylgruppen sind bevorzugt Methyl.

Die diesen Silylierungsreagenzien zugrundeliegenden Silanylverbindungen, müssen, um mit den beschriebenen Brückengruppen reagieren zu können, halogeniert, insbesondere chloriert sein. Gemische von Verbindungen dieses Typs fallen als Nebenprodukt der sogenannten Direktsynthese, wie sie beispielsweise von R. Schliebs und J. Ackermann in Chem. i. u. Zt. 21, 121 (1987) beschrieben wird, in technischen Mengen an. Weiterhin lassen sich Verbindungen dieses Typs gezielt in guten Ausbeuten ausgehend von einfachsten Siliziumverbindungen synthetisieren. Dazu findet man ausführliche Angaben beispielsweise in folgenden Schriften: M. Kumada, K. Tamao in Adv. Organomet. Chem. 6, 19 (1968) und E. Hengge in Topics in Current Chemistry 51, 1 (1974).

Die erfindungsgemäßen Bindemittel mit den beschriebenen Silanylgruppen in den Seitenketten, weisen alle die aufgabengemäß gewünschten Eigenschaften auf. Hierbei sind insbesondere zu nennen:

- Sie sind in einfacher Weise herzustellen und weisen eine ausreichende Löslichkeit in wäßrigem Alkali,
- eine sehr hohe Plasmaätzbeständigkeit, z.B. beim reaktiven Ionenätzen mit Sauerstoff,
- eine überraschend hohe Lagerstabilität sowie
- eine hohe Beständigkeit gegenüber Strahlung, mit der heutzutage die bildmäßige Belichtung von lichtempfindlichen Gemischen vorgenommen werden kann (I- und H-Line Belichtungsgeräte, Wellenlänge größer als 300 nm) und mit der nach dem bisherigen Stand der Technik nicht gerechnet werden konnte.

Als besonders bevorzugte Beispiele für Pfropfungsreagenzien werden folgende Verbindungen genannt: 2,3-Epoxy-1-propanol, Diisopropyliden-triglycerin-glycidether, Triglycerin-glycidether, 2-Ethoxy-4-(2,3-epoxypropoxy)-1,3-benzdioxol und das Umsetzungsprodukt aus 2-Ethoxy-4-hydroxy-1,3-benzdioxol mit Toluol-2,4-diisocyanat.

Als besonders vorteilhaft hinsichtlich kommerzieller Verfügbarkeit, Reaktivität und anwendungstechnischer Eigenschaften erweist sich 2,3-Epoxy-1-propanol.

Es können auch jeweils mehrere Silylierungsreagenzien und/oder Pfropfungsreagenzien gleichzeitig mit einem bzw. auch mehreren Bindemitteltypen umgesetzt werden. Die dabei gewählten Reaktionsbedingungen, z.B. Temperatur, Zeit, Lösemittel und Substanzkonzentration hängen von der relativen Reaktivität der Reagenzien bezüglich ihrer Umsetzung mit dem Bindemittel bzw. den Bindemitteln ab und lassen sich vom Fachmann, ohne daß er erfinderisch tätig werden muß, einfach bestimmen.

Ferner wird ein lichtempfindliches Gemisch enthaltend die erfindungsgemäßen Bindemittel beansprucht.

Die erfindungsgemäßen lichtempfindlichen Gemische enthalten als wesentliche Bestandteile eine Komponente bzw. ein System, die bzw. das lichtempfindlich ist sowie das Bindemittel, das in der Seitenkette Silanylgruppen aufweist und im wäßrigen Alkali löslich ist.

In den lichtempfindlichen Gemischen können die erfindungsgemäßen Bindemittel mit anderen, nicht silylierten Bindemitteln, gemischt werden. Beispielsweise erweisen sich als vorteilhaft Phenolharze, die auch zur Gewinnung des erfindungsgemäßen Bindemittels herangezogen worden sind.

Der Zusatz solcher Filmbildner soll den Anteil von 40 Gew.-% bezüglich des Feststoffgehalts des lichtempfindlichen Gemisches nicht überschreiten, um die Beständigkeit gegenüber dem reaktiven Ionenätzen nicht zu vermindern.

Die Menge des Bindemittels im lichtempfindlichen Gemisch beträgt im allgemeinen 50 bis 95 Gew.-%, bevorzugt 70 bis 90 Gew.-%, bezogen auf die nichtflüchtigen Bestandteile des Gemisches.

Als lichtempfindliche Komponenten bzw. als System werden solche Verbindungen genannt, die im lichtempfindlichen Gemisch entweder nach Einwirkung von aktinischer Strahlung gegenüber einer wäßrig alkalischen Entwicklerlösung löslicher werden oder auch solche Verbindungen, die unter den genannten Bedingungen unlöslich werden, d.h. eine Vernetzungsreaktion auslösen. Im ersten Fall handelt es sich um positiv arbeitende lichtempfindliche Gemische, im zweiten Fall um negativ arbeitende. Die positiv arbeitenden Gemische werden bevorzugt.

Zu den positiv arbeitenden lichtempfindlichen Verbindungen zählen Verbindungen aus der Stoffklasse der o-Chinondiazide, die in J. Kosar "Light Sensitive Systems", John Wiley and Sons/New York, 1965, Seiten 343 bis 351 beschrieben werden.

Vorzugsweise sind die Amide und Ester von o-Naphtho- bzw. o-Benzochinondiaziden zu nennen. Bis-1,2-Naphthochinon-2-diazidsulfonsäureamide werden z.B. in der EP-A-0 231 855 beschrieben. Bevorzugt sind allerdings die Ester mit Mono- bis Polyhydroxybenzophenonen, Mono-bis Polyhydroxyacylophenonen, Gallussäuren, Phloroglucin, Mono- bis Polyhydroxydiphenylmethanen, Bis-(hydroxyphenyl)-valeriansäureester zu nennen. Besonders bevorzugt sind die Trihydroxyverbindungen, insbesondere Trihydroxybenzophenon, und hierunter wiederum die Trisester mit o-Naphtho- bzw. o-Benzochinondiazidsulfonsäuren. In Frage kommen die Diazid-4- und -5-sulfon säureester, aber auch gemischte Ester, insbesondere Trisester aus den -4- und -5-sulfonsäuren. Verbindungen dieses Typs sind in den DE-C-938 239, 21 31 377, 25 47 905 und 28 28 017 beschrieben.

Die Menge an o-Chinondiazidverbindungen beträgt im allgemeinen 5 bis 50 Gew.-%, bevorzugt 10 bis 35 Gew.-%, bezogen auf die nichtflüchtigen Bestandteile des lichtempfindlichen Gemisches.

Als lichtempfindliche Verbindungen in dem erfindungsgemäßen positiv arbeitenden lichtempfindlichen Gemisch kommen auch Komponenten in Frage, die beim Bestrahlen vorzugsweise eine starke Säure (Starter) bilden bzw. abspalten in Kombination mit Verbindungen, die durch Säure spaltbar sind. Die Starter sind Diazonium-, Phosphonium-, Sulfonium- und Iodonium-Salze, Halogenverbindungen, o-Chinondiazidsulfochloride und -ester sowie Organometall-Organohalogen-Kombinationen.

Die Diazonium-, Phosphonium-, Sulfonium- und Iodonium-Verbindungen werden in der Regel eingesetzt in Form ihrer in organischen Lösungsmitteln löslichen Salze, meist als Abscheidungsprodukt mit komplexen Säuren wie Borfluorwasserstoffsäure, Hexafluorphosphor-, Hexafluorantimon- und -arsensäure. U.a. werden diese Verbindungen auch in der DE-A-36 01 264 genannt.

Unter die Halogenverbindungen zählen insbesondere Triazinderivate, die aus den US-A-3 515 552, 3 536 489 und 3 779 778 sowie den DE-C-27 18 259, 33 37 024, 33 33 450, 23 06 248, 22 43 621 und 12 98 414 bekannt sind. Diese können aber auch in Kombination mit anderen Photoinitiatoren wie Oxazolen, Oxadiazolen oder Thiazolen, aber auch untereinander in Mischungen eingesetzt werden.

Es sind aber auch Oxazole, Oxadiazole, Thiazol oder 2-Pyrone bekannt, die Trichlor- oder Tribrommethylgruppen enthalten (DE-A-30 21 599, 30 21 590, 28 51 472, 29 49 396 sowie EP-A-0 135 348 und 0 135 863).

Ebenso zählen unter diesen Oberbegriff insbesondere auch aromatische Verbindungen, die kernständiges Halogen, vorzugsweise Brom aufweisen. Solche Verbindungen sind aus der DE-A-26 10 842 bekannt oder werden in der deutschen Patentanmeldung P 37 30 784.3 beschrieben.

Als Vertreter einer Kombination mit einem Thiazol sei eine mit 2-Benzoylmethylen-3-methyl-2,3-dihydronaphtho-[1,2-d][1,3]thiazol genannt (DE-A-28 51 641 und DE-A-29 34 758). Ein Gemisch einer Trihalogenmethylverbindung mit N-Phenylacridon ist aus der DE-A-26 10 842 bekannt.

Ebenso stehen $\alpha$-Halogencarbonsäureamide (DE-A-27 18 200) oder Tribrommethyl-phenylsulfone (DE-A-35 03 113), die z.B. durch Benzophenon, Benzil oder Michlers Keton sensibilisiert werden können, zur Verfügung.

Beispiele für geeignete Starter sind:
4-(Di-n-propyl-amino )-benzoldiazoniumtetrafluoroborat, 4-p-Tolylmercapto-2,5-diethoxy-benzoldiazoniumhexafluorphosphat und -tetrafluoroborat, Diphenylamin-4-diazoniumsulfat, 4-Methyl-6-trichlormethyl-2-pyron, 4-(3,4,5-Trimethoxystyryl)-6-trichlormethyl-2-pyron, 4-(4-Methoxy-styryl )-6-(3,3,3-trichlor-propenyl)-2-pyron, 2-Trichlormethlybenzimidazol, 2-Tribrommethylchinolin, 2,4-Dimethyl-1-tribromacetyl-benzol, 3-Nitro-1-tribromacetyl-benzol, 4-Dibromacetyl-benzoesäure, 1,4-Bis-dibrommethylbenzol, Tris-dibrommethyl-s-triazin, 2-(6-Methoxy-[2]naphthyl)-, 2-[1]Naphthyl-, 2-[2]Naphthyl-, 2(4-Ethoxyethyl-[1]naphthyl)-, 2(Benzopyran-3-yl)-, 2-(4-Methoxy-[1]anthryl)-, 2-(4-Styryl-phenyl)-, 2-[9]Phenanthryl-4,6-bis-trichlormethyl-s-triazin und die in den Beispielen angeführten Verbindungen.

Die Menge des Starters kann je nach seiner chemischen Natur und der Zusammensetzung des Gemisches sehr verschieden sein. Günstige Ergebnisse werden erhalten mit etwa 0,1 bis 10 Gew.-%, bezogen auf die nichtflüchtigen Bestandteile des Gemisches, bevorzugt sind 0,2 bis 5 Gew.-%. In der Regel können aber alle beschriebenen licht- bzw. strahlungsempfindlichen Verbindungen durch Photosensibilisatoren in ihrer Effektivität unterstützt werden. Zu nennen sind z.B. Anthracen, Phenanthren, Pyren, 1,2-Benzanthren, Thiazine, Pyrazoline, Benzofurane, Benzophenone, Fluorenone, Anthrachinone sowie Cumarinderivate. Ihr Gehalt liegt bei 0,01 bis 5 Gew.-%, bezogen auf das Gewicht des strahlungsempfindlichen Gemisches.

Als durch Säure spaltbares Material in dem erfindungsgemäßen lichtempfindlichen Gemisch haben sich vor allem folgende Verbindungsklassen bewährt:

a) solche mit mindestens einer Orthocarbonsäureester-und bzw. oder Carbonsäureamidacetalgruppierung, wobei die Verbindungen auch polymeren Charakter haben und die genannten Gruppierungen als verknüpfende Elemente in der Hauptkette oder als seitenständige Substituenten auftreten können,
b) Oligomer- oder Polymerverbindungen mit wiederkehrenden Acetal- und/oder Ketalgruppierungen in der Hauptkette,
c) Verbindungen mit mindestens einer Enolether- oder N-Acyliminocarbonatgruppierung,
d) cyclische Acetale oder Ketale von $\beta$-Ketoestern oder -amiden,
e) Verbindungen mit Silylenolethergruppierungen und
f) Monoacetale bzw. Monoketale, deren Aldehyd- bzw. Ketonkomponente eine Löslichkeit im Entwickler zwischen 0,1 und 100 g/l aufweisen,
g) Ether auf Basis tertiärer Alkohole,
h) Carbonsäureester und Carbonate tertiärer, allylischer oder benzylischer Alkohole.

Durch Säure spaltbare Verbindungen des Typs a) als Komponenten strahlungsempfindlicher Gemische sind in der EP-A-0 022 571 und der DE-A-26 10 842 ausführlich beschrieben; Gemische, die Verbindungen des Typs b) enthalten, sind in der DE-C-23 06 248 und der DE-C-27 18 254 dargestellt; Verbindungen des Typs c) werden in den EP-A-0 006 626 und 0 006 627 beschrieben; Verbindungen des Typs d) werden in der EP-A 0 202 196 vorgestellt; Verbindungen des Typs e) findet man in der deutschen Patentanmeldung P 37 30 783.5, während Verbindungen vom Typ f) in den deutschen Patentanmeldungen P 37 30 785.1 und P 37 30 787.8 behandelt werden. Verbindungen vom Typ g) werden z. B. in der US-A-4 603 101 beschrieben, Verbindungen vom Typ h) z. B. in der US-A-4 491 628 und von J. M. Fréchet et al., J. Imaging Sci. 30, 59-64 (1986).

Es können auch Mischungen der genannten säurespaltbaren Materialien eingesetzt werden. Bevorzugt ist allerdings ein säurespaltbares Material, welches einem der oben genannten Typen zuzuordnen ist. Besonders bevorzugt sind von den Materialien diejenigen, die mindestens eine durch Säure spaltbare C-O-C-Bindung aufweisen, sowie insbesondere solche, die den Typen a), b), c) und h) angehören. Unter Typ b) sind insbesondere die polymeren Acetale hervorzuheben.

Der Gehalt an säurespaltbarem Material in dem erfindungsgemäßen lichtempfindlichen Gemisch sollte bei 5 bis 45 Gew.-%, vorzugsweise bei 5 bis 30 Gew.-%, jeweils bezogen auf das Gesamtgewicht der Schicht, liegen.

Als lichtempfindliche Verbindungen in den erfindungsgemäßen negativ arbeitenden lichtempfindlichen Gemischen kommen insbesondere aromatische Azidoverbindungen in Frage. Verbindungen dieses Typs werden genannt von Kosar in "Light Sensitive Systems", John Wiley & Sons, Inc., New York/London/Sydney, 1965, Seiten 330 bis 336.

Aromatische Azidoverbindungen werden im allgemeinen in der DE-A-27 57 056 genannt. Insbesondere kommen in Frage 4,4′-Diazidostilben, 4,4′-Diazidochalcon, 4,4′-Diazidobenzophenon, 2,6-Bis(4′-azidobenzyliden)cyclohexanon, 2,6-Bis(4,4′-azidobenzal)-4-methylcyclohexan und 1,6-Diazidopyren.

Ebenso können lichtempfindliche polymere Ester mit endständigen aromatisch gebundenen Azidogruppen im erfindungsgemäß lichtempfindlichen Gemisch eingesetzt werden. Verbindungen dieser Art werden in der DE-A-22 51 828 beschrieben, bevorzugte Vertreter der diesen Estern zugrunde liegenden Säurekomponenten sind:
4-Azido-$\alpha$-brom-$\delta$-chlorcinnamylidenessigsäure, 4-Azido-$\delta$-chlorcinnamylidenessigsäure, 4-Azido-$\alpha$-cyan-$\delta$-chlorcinnamylidenessigsäure, 4-Azido-$\alpha$-cyancinnamylidenessigsäure, 3-Azido-benzyliden-$\alpha$-cyanessigsäure, 4-Azidobenzyliden-$\alpha$-cyanessigsäure, 4-Azido-2-chlorbenzyliden-$\alpha$-cyanessigsäure, 4-Azido-3,5-dibrombenzyliden-$\alpha$-cyanessigsäure, 3-Azido-4-methyl-benzyliden-$\alpha$-cyanessigsäure, 3-Azido-3-methoxybenzyliden-$\alpha$-cyanessigsäure.

Als Aryldiazide können ebenso Azidonitrone (DE-A-15 72 066), Azidoazomethine (DE-A-15 72 067), Azidostyrylverbindungen (DE-A-15 72 068, DE-A-15 72 069, DE-A-15 72 070) und Azidochalconverbindungen (DE-A-15 97 614) verwendet werden.

Als hydroxylgruppenhaltige Verbindungen werden insbesondere Epoxyharze, Polyvinylalkohol, Celluloseverbindungen oder Novolakharze angesehen.

Die lichtempfindlichen Verbindungen für das erfindungsgemäße negativ arbeitende lichtempfindliche Gemisch werden zu 0,5 bis 40 Gew.-%, insbesondere bevorzugt zu 1 bis 10 Gew.-%, bezogen auf die nicht flüchtigen Bestandteile der Schicht, eingesetzt.

Das erfindungsgemäße lichtempfindliche Gemisch weist einen Siliciumgehalt von 7 bis 30 Gew.-%, insbesondere 8 bis 20 Gew.-% und besonders bevorzugt 9 bis 14 Gew.-%, auf.

Ferner können den erfindungsgemäßen positiv und negativ arbeitenden lichtempfindlichen Gemischen ggf. Farbstoffe, Pigmente, Weichmacher, Netzmittel und Verlaufmittel, aber auch Polyglykole, Celluloseether, z.B. Ethylcellulose, zur Verbesserung spezieller Erfordernisse wie Flexibilität, Haftung und Glanz

zugesetzt werden.

Vorzugsweise wird das erfindungsgemäße lichtempfindliche Gemisch in Lösungsmitteln wie Ethylenglykol, Glykolethern wie Glykolmonomethylether, Glykoldimethylether, Glykolmonoethylether oder Propylenglykolmonoalkylethern, insbesondere Propylenglykolmethylether; aliphatische Estern wie Ethylacetat, Hydroxyethylacetat, Alkoxyethylacetat, $\eta$-Butylacetat, Propylenglykolmonoalkyletheracetat, insbesondere Propylenglykolmethyletheracetat oder Amylacetat; Ethern wie Dioxan, Ketonen wie Methylethylketon, Methylisobutylketon, Cyclopentanon und Cyclohexanon; Dimethylformamid, Dimethylacetamid, Hexamethylphosphorsäureamid, N-Methyl-pyrrolidon, $\gamma$-Butyrolacton, Tetrahydrofuran, und in Mischungen derselben gelöst. Besonders bevorzugt werden Glykolether, aliphatische Ester sowie Ketone.

Die mit den übrigen Bestandteilen des lichtempfindlichen Gemisches entstehenden Lösungen haben in der Regel einen Feststoffgehalt von 5 bis 60 Gew.-%, vorzugsweise 10 bis 50 Gew.-%.

Erfindungsgemäß wird ferner ein Verfahren zur Herstellung der in wäßrigem Alkali löslichen, Silanylgruppen in der Seitenkette enthaltenden Bindemittel beansprucht. Das Verfahren ist dadurch gekennzeichnet, daß ein aromatische und/oder aliphatische Hydroxylgruppen enthaltendes Bindemittel mit dem Silylierungsreagenz in einem aprotischen Lösemittel, insbesondere einem aliphatischen bzw. cycloaliphatischen Ether oder Ester bei einer Temperatur bis 120° C, insbesondere 40 bis 90° C, umgesetzt wird. Gegebenenfalls kann vorher das Bindemittel in einem dem obengenannten Typ entsprechenden Lösemittel, insbesondere demselben, mit einem Pfropfungsreagenz der allgemeinen Formel II umgesetzt werden. Diese Reaktion wird vorzugsweise bei Temperaturen über 0° C, insbesondere bei 60 bis 90° C durchgeführt.

Sofern das Bindemittel sowohl silyliert als auch gepfropft werden soll, werden beide Reaktionen zwar nacheinander, aber bevorzugt in dem Reaktionsgefäß kontinuierlich, d.h. ohne Isolierung des jeweils zuerst gebildeten Produkts durchgeführt.

Beide Reaktionen können, da es sich bei der Bindungsbildung jeweils um eine Reaktion mit einer Hydroxylgruppe handelt, unter Gegenwart entsprechender Katalysatoren durchgeführt werden. Katalysatoren dieser Art werden von L. Thiele in Acta Polymerica 30, 323 (1979) und von P. Schnurrenberger, M.F. Züger, D. Seebach in Helv. Chim. Acta 65, 1197 (1982) genannt.

Die Zugabe eines Katalysators vom Typ der tertiären Amine, insbesondere Diazabicyclo 2.2.2 octan ist dann besonders vorteilhaft, wenn Isocyanatgruppen oder Epoxidgruppen als funktionelle Gruppen C zur Bindungsbildung mit der Hydroxylfunktion des Bindemittels bzw. der Pfropfungsgruppen eingesetzt werden sollen.

Die Zugabe eines Katalysators vom Typ der Orthotitansäureester, insbesondere Titansäuretetraethylester, ist dann besonders vorteilhaft, wenn die Knüpfung einer kovalenten Bindung zwischen dem Silylierungsreagenz und der Hydroxylfunktion des Bindemittels durch eine Umesterungsreaktion bewerkstelligt werden soll.

Die Isolierung erfolgt durch Ausfällen des jeweiligen Produkts in einem Wasser enthaltenden organischen Lösemittel(gemisch), dem ggf. eine Säure, insbesondere anorganische Säuren, zugesetzt wird. Das Zusetzen von Säuren ist erforderlich, um die ggf. durch säurelabile Gruppen geschützten Hydroxylgruppen der Pfropfungseinheiten freizusetzen.

Erfindungsgemäß wird ferner ein lichtempfindliches Aufzeichnungsmaterial beansprucht, im wesentlichen bestehend aus einem Substrat, ggf. einer darauf aufgebrachten Planarisierungsschicht und dem darauf aufgetragenen lichtempfindlichen Gemisch.

Als Substrate kommen alle Materialien in Frage, aus denen Kondensatoren, Halbleiter, mehrlagige gedruckte Schaltungen oder integrierte Schaltkreise bestehen bzw. hergestellt werden können. Insbesondere sind Oberflächen aus reinem Silicium und thermisch oxidiertem und/oder mit Aluminium beschichtetem Siliciummaterial zu nennen, die gegebenfalls auch dotiert sein können, einschließlich aller anderen in der Halbleitertechnologie üblichen Substrate wie beispielsweise Siliciumnitrid, Galliumarsenid, Indiumphosphid. Weiterhin kommen in Frage die aus der Flüssigkristalldisplay-Herstellung bekannten Substrate wie Glas, Indium-Zinnoxid; ferner Metallplatten und -folien, beispielsweise aus Aluminium, Kupfer, Zink; Bimetall- und Trimetallfolien, aber auch elektrisch nicht leitende Folien, die mit Metallen bedampft sind, gegebenenfalls mit Aluminium beschichtete $SiO_2$-Materialien und Papier. Diese Substrate können einer Temperatur-Vorbehandlung unterzogen werden, oberflächlich angerauht, angeätzt oder zur Erzielung erwünschter Eigenschaften, wie z. B. Erhöhung der Hydrophilie, mit Chemikalien behandelt sein.

In einer besonderen Ausführungsform kann das lichtempfindliche Gemisch zur besseren Haftung in dem Resist oder zwischen dem Resist und dem Substrat einen Haftvermittler enthalten. Bei Silicium- bzw. Siliciumdioxid-Substraten kommen hierfür Haftvermittler vom Aminosilantyp, wie z.B. 3-Aminopropyl-triethoxysilan oder Hexamethyl-disilazan in Frage.

Beispiele für Träger, die zur Herstellung von photomechanischen Aufzeichnungsschichten wie Druckformen für den Hochdruck, den Flachdruck, den Siebdruck, den Tiefdruck sowie von Reliefkopien Verwendung

finden können, sind Aluminiumplatten, ggf. anodisch oxidiert, gekörnte und/oder silikatisierte Aluminiumplatten, Zinkplatten, Stahlplatten, die ggf. mit Chrom bearbeitet wurden, sowie Kunststoffolien oder Papier.

Beim sogenannten Zweilagenverfahren wird auf die meist komplizierte und unterschiedliche hohe Substrattopographie eine Planarisierungsschicht aufgetragen. In diesem Fall wurde das Substrat vorher schon photolithographisch bearbeitet, d.h. die Oberfläche des Substrats wurde mit Hilfe einer aufgetragenen Photoresistlösung, anschließendem Belichten und Entwickeln schon strukturiert. Bevor ein solches bearbeitetes Substrat wiederum photolithographisch bearbeitet werden kann, unter Zuhilfenahme einer weiteren Photoresistschicht, werden in der Regel die Unebenheiten des Substrats, bevor die Resistschicht aufgetragen wird, durch eine Planarisierungsschicht ausgeglichen. Diese Schichten bestehen in der Regel aus Materialien, die sich durch reaktives Ionenätzen gut entfernen lassen. Als Beispiele werden genannt: ggf. thermisch behandelte Novolak-Harze, Polyimide, ggf. thermisch behandelte Positiv-Resists auf Novolak-Basis, Polystyrol, Polymethyl(meth)acrylat, Polyvinylacetat und daraus hergestellte Mischungen. Solche Schichten haben in der Regel eine Dicke von 0,5 bis 5 $\mu$m.

Das erfindungsgemäße Aufzeichnungsmaterial wird bildmäßig belichtet. Quellen aktinischer Strahlung sind: Metallhalogenidlampen, Kohlebogenlampen, Xenonlampen und Quecksilberdampflampen. Es kann auch eine Belichtung mit energiereicher Strahlung wie Laser-, Elektronen oder Röntgenstrahlung erfolgen. Als Laser werden insbesondere Helium/Neon-Laser, Argon-Laser, Krypton-Laser sowie Helium/Cadmium-Laser genannt.

Die Schichtstärke der lichtempfindlichen Schicht vari iert in Abhängigkeit von ihrem Einsatzgebiet. Sie beträgt zwischen 0,1 und 100 $\mu$m, bei Anwendungen zur Fertigung von mikroelektronischen Schaltkreisen insbesondere zwischen 0,3 und 10 $\mu$m.

Zur Herstellung des lichtempfindlichen Aufzeichnungsmaterials wird nach dem Aufbringen des Materials für die Planarisierungsschicht, je nachdem ob das Substrat eben oder uneben ist, das lichtempfindliche Gemisch auf das Substrat aufgetragen. Es kann durch Aufsprühen, Fließbeschichten, Walzen, Schleuderbeschichten und Tauchbeschichten erfolgen. Danach wird das Lösungsmittel durch Verdampfen entfernt, so daß auf der Oberfläche des Substrates die strahlungsempfindliche Schicht zurückbleibt. Die Entfernung des Lösemittels kann gegebenfalls durch Erhitzen der Schicht auf Temperaturen von bis zu 140 °C gefördert werden. Das Gemisch kann aber auch zunächst auf obengenannte Weise auf den Zwischenträger aufgetragen werden, von dem aus es unter Druck und erhöhter Temperatur auf das endgültige Trägermaterial übertragen wird.

Anschließend wird die Schicht bildmäßig belichtet. Üblicherweise wird aktinische Strahlung verwendet, aber auch UV-, Röntgen- oder Elektronenstrahlung sind bevorzugt. Zur Belichtung werden UV-Lampen verwendet, die Strahlung einer Wellenlänge von 200 bis 500 nm mit einer Intensität von 0,5 bis 60 mW/cm$^2$ aussenden. In der lichtempfindlichen Schicht wird anschließend durch Entwicklung ein Bildmuster freigelegt, in dem die Schicht mit einer Entwicklungslösung behandelt wird, die die bestrahlten Bereiche des Materials löst bzw. entfernt.

Als Entwickler werden Lösungen von alkalischen Reagenzien wie z.B. Silikaten, Metasilikaten, Hydroxiden, Hydrogen- bzw. Dihydrogenphosphaten, Carbonaten bzw. Hydrogencarbonaten, insbesondere von Alkali- oder auch organische Basen wie Cholin oder Ammoniumionen, Tetramethylammoniumhydroxid, aber auch Ammoniak und dergleichen verwendet. Der Gehalt dieser Substanzen in der Entwicklerlösung beträgt im allgemeinen 0,1 bis 15 Gew.-%, vorzugsweise 0,5 bis 5 Gew.-%, bezogen auf das Gewicht der Entwicklerlösung.

Besonders vorteilhaft hinsichtlich Gleichmäßigkeit der Aufentwicklung wirken sich Zusätze von oberflächlichen aktiven Verbindungen vom Typ der alkoxylierten Phenole aus.

Die entwickelten Resiststrukturen werden ggf. nachgehärtet. Dies geschieht im allgemeinen dadurch, daß man die Resiststruktur auf einer hot-plate bis zu einer Temperatur unter der Fließtemperatur erhitzt und anschließend mit UV-Licht einer Xenon-Quecksilber-Dampflampe (Bereich von 200 bis 250 nm) ganzflächig belichtet. Durch diese Nachhärtung werden die Resiststrukturen vernetzt, so daß die Strukturen eine Fließbeständigkeit im allgemeinen bis zu Temperaturen von über 200 °C aufweisen. Die Nachhärtung kann auch ohne Temperaturerhöhung unter Einstrahlung von UV-Licht erfolgen. Dies gilt insbesondere dann, wenn energiereiches Licht verwendet wird, z.B. Elektronenstrahlung.

Die durch Entwicklung freigelegten Bereiche des Substrates bzw. der Planarisierungsschicht, sofern eine solche vor dem Aufbringen des Photoresists auf das Substrat aufgetragen worden ist, werden anschließend geätzt. Die besondere Resistenz der beim Entwickeln zurückgebliebenen Resiststrukturen gegenüber dem reaktiven Ionenätzen wird dabei anhand von Schichtdickenmessungen mit einem Schichtendickenmeßgerät des Fabrikats Sloan Dektak II bestimmt.

Für die Strukturübertragung des photolithographischen freigelegten Bereich auf das Substrat durch das Plasmaätzen werden folgende Prozeßparameter eingehalten. Beim reaktiven Sauerstoffätzen insbesondere

ein Sauerstoff-Druck von 1 bis 100 mTorr, eine eingestrahlte Hochfrequenzleistung von 50 bis 400 W.

Die folgenden Beispiele sollen die Erfindung näher beschreiben und nicht auf sie beschränkend wirken. Die Silylierungsreagenzien sind in der DE-A 38 10 632 beschrieben.

Die zum Vergleich hergestellten, lediglich Monosilangruppen aufweisenden Bindemittel weisen die Vorteile, die mit den erfindungsgemäß hergestellten Monomeren erzielbar sind, nicht auf. Insbesondere weisen die Bindemittel, die Monosilangruppen enthalten, im Vergleich zu denen, die mit den erfindungsgemäßen Silylierungsreagenzien umgesetzt werden, unter der Voraussetzung, daß in beiden Fällen die Molverhältnisse der Umsetzungsedukte gleich sind, und im Falle der erfindungsgemäßen Bindemittel gerade eine hinreichende Plasmaätzbeständigkeit erreicht wird, keine hinreichende Plasmaätzbeständigkeit auf.

Im folgenden wird die Herstellung von drei verschiedenen Verbindungen, die zur Pfropfung des Bindemittels geeignet sind, beschrieben:

Herstellungsbeispiel 1: Darstellung von Triglyceringlycidether

In einem 100 ml Kolben löst man 20 g Diisopropylidentriglyceringlycidether in 20 ml Tetrahydrofuran und gibt dann 2 ml Wasser und 1 Tropfen konzentrierte Salzsäure hinzu. Man läßt 3 h bei 30° C rühren und versetzt dann mit 0,5 g Kaliumcarbonat und läßt 1 h rühren. Die Lösung wird filtriert und am Rotationsverdampfer vom Lösemittel befreit. Der Rückstand wird im Ölpumpenvakuum bis zur Gewichtskonstanz getrocknet. Es verbleibt ein viskoses, farbloses Öl, das für die nachfolgenden Umsetzungen mit den Bindemitteln ausreichend rein ist.

Das Edukt Diisopropylidentriglyceringlycidether ist ein Entwicklungsprodukt der Firma SOLVAY.

Herstellungsbeispiel 2: Darstellung von 2-Ethoxy-4-O-(2,3-epoxypropyl)-1,3-benzdioxol

In einem 100 ml Kolben wird eine Mischung aus 10,9 g 2-Ethoxy-4-hydroxy-1,3-benzdioxol, 5,5 g Epichlorhydrin, 0,5 g Kaliumjodid und 10 g Kaliumcarbonat 8 h unter Rühren am Rückfluß erhitzt. Anschließend filtriert man das ausgefallene Salz und das überschüssige Kaliumcarbonat ab und engt die Lösung am Rotationsverdampfer ein. Der ölige Rückstand wird in einem Kugelrohrapparat destilliert. Man erhält das Produkt in 35 %iger Ausbeute als farbloses, nicht kristallisierendes Öl.

Das Edukt 2-Ethoxy-4-hydroxy-1,3-benzdioxol kann nach einer Vorschrift von F. Dietl, G. Gierer und A. Merz in Synthesis S. 626 (1985) hergestellt werden.

Herstellungsbeispiel 3: Darstellung des Umsetzungsproduktes aus 2-Ethoxy-4-hydroxy-1,3-benzdioxol und Toluylen-2,4-diisocyanat

In einem 100 ml Kolben werden 17,4 g Toluol-2,4-diisocyanat in 50 ml Tetrahydrofuran unter Stickstoff-Atmosphäre vorgelegt. Dazu gibt man 18,2 g 2-Ethoxy-4-hydroxy-1,3-benzdioxol und 0,02 g Diazabicyclo [2.2.2] -octan. Anschließend läßt man die Reaktionslösung noch 8 h bei 50° C rühren und zieht dann das Lösemittel am Rotationsverdampfer ab. Es verbleibt ein hochviskoser Rückstand, der aber nicht kristallisiert und für die nachfolgenden Umsetzungen mit den Bindemitteln ausreichend rein ist.

| | |
|---|---|
| Produkt aus Herstellungsbeispiel 1 | 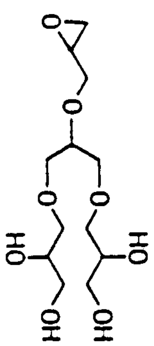 |
| Produkt aus Herstellungsbeispiel 2 | 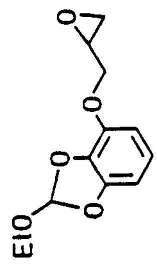 |
| Produkt aus Herstellungsbeispiel 3 | 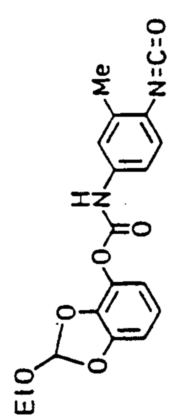 |

Me = Methyl
Et = Ethyl

Die zur Herstellung der erfindungsgemäßen Bindemittel notwendige Silylierungsreagenzien werden in der gleichzeitig eingereichten Deutschen Patentanmeldung (int.Nr. Hoe 88/K 022) beschrieben.

Im folgenden wird die Herstellung der erfindungsgemäß beanspruchten Bindemittel beschrieben.

Herstellungsbeispiel 4:

In einen 100 ml Kolben werden unter Argon-Atmosphäre nacheinander folgende Substanzen eingewogen:
10 g eines Kresol-Formaldehyd-Novolaks mit einem Erweichungspunkt von 147 bis 150° C,
5 g 2-(Pentamethyldisilanyl)-ethylisocyanat
0,05 g Diaza-bicyclo [2.2.2] octan in
20 ml 1,2-Dimethoxy-ethan.

Durch Rühren bei Raumtemperatur entsteht nach kurzer Zeit eine homogene Lösung.

Der Kolben wird 6 h bei 60° C thermostatisiert. Anschließend läßt man die Polymerlösung langsam in eine Mischung aus 400 ml Methanol und 400 ml Wasser einlaufen. Für eine gleichmäßige Ausfällung ist die Anwendung eines Hochgeschwindigkeitsrührwerkes (Fabrikat IKA-Rührwerk RE 166) vorteilhaft.

Das ausgefällte Polymer wird mit Hilfe einer Glassinternutsche abgesaugt und im Vakuumtrockenschrank 6 h bei 90° C getrocknet. Die Ausbeute beträgt 14,5 g (95 % der Theorie).

Das Polymer zeigt folgende Analysenwerte:

| | |
|---|---|
| OH-Zahl (bestimmt nach DIN 53240): | 204 |
| N-Gehalt: | 2,6 % |
| Si-Gehalt (Elementaranalyse): | 9,1 % |
| Glastemperatur: | 103 ° C |

Herstellungsbeispiel 5:

In diesem Beispiel wird das Bindemittel neben mit dem Silylierungsreagenz zuerst mit einem Pfropfungsreagenz zur Modifizierung der Alkalilöslichkeit des entstehenden Produktes umgesetzt.

In einen 100 ml Kolben werden unter Argon-Atmosphäre nacheinander folgende Substanzen eingewogen:
10 g eines Kresol-Formaldehyd-Novolaks mit einem Erweichungspunkt von 105 bis 120° C,
0,92 g 2,3-Epoxy-propan-1-ol (Glycidol),
0,05 g Diaza-bicyclo [2.2.2] octan in
30 ml Diethylenglykoldimethylether.

Durch Rühren bei Raumtemperatur entsteht nach kurzer Zeit eine homogene Lösung.

Der Kolben wird 6 h bei 85° C thermostatisiert. Anschließend läßt man die Lösung auf Raumtemperatur abkühlen und gibt 5 g 2-(Pentamethyldisilanyl)-ethylisocyanat hinzu und mischt die Lösung gut durch. Schließlich wird die Lösung 8 h bei 60° C thermostatisiert.

Die Ausfällung des Polymers erfolgt auf die gleiche Weise, wie in Herstellungsbeispiel 4 beschrieben. Die Ausbeute beträgt 14,6 g (91 % der Theorie).

Das Polymer zeigt folgende Analysewerte:

| | |
|---|---|
| OH-Zahl (bestimmt nach DIN 53240): | 230 |
| N-Gehalt: | 2,8 % |
| Si-Gehalt (Elementaranalyse): | 9,0 % |
| Glastemperatur: | 100 ° C |

Herstellungsbeispiel 6:

Die Darstellung und Aufarbeitung des polymeren Bindemittels erfolgt analog zu der in Herstellungsbeispiel 4 angegebenen Art und Weise.

Folgende Rezepturbestandteile werden verwendet:
10 g eines Kondensationsproduktes stöchiometrischer Mengen Pyrogallol und Aceton mit einem Gewichtsmittel des Molekulargewichts von $\overline{M}_w$ = 1.470
8 g 2-(Pentamethyldisilanyl)-ethylisocyanat,
0,08 g Diaza-bicyclo [2.2.2] octan in
30 ml 1,2-Dimethoxy-ethan.

Die Ausbeute beträgt 16,7 g (93 % der Theorie).

Das Polymer zeigt folgende Analysenwerte:

| | |
|---|---|
| OH-Zahl (bestimmt nach DIN 53240): | 277 |
| Si-Gehalt (Elementaranalyse): | 12,1 % |

Herstellungsbeispiel 7:

Im folgenden Beispiel wird das Bindemittel mit zwei verschiedenen Silylierungsreagenzien umgesetzt.

Die Darstellung und Aufarbeitung des polymeren Bindemittels erfolgt analog zu der in Herstellungsbeispiel 4 angegebenen Art und Weise.

Folgende Rezepturbestandteile werden verwendet

10 g eines Kondensationsproduktes stöchiometrischer Mengen Pyrogallol und Aceton mit einem Gewichtsmittel des Molekulargewichts von $\overline{M}_w$ = 1.470

4 g 2-(Pentamethyldisilanyl)-ethylisocyanat,

4 g (Tristrimethylsilyl)silanyl-$\beta$-ethylisocyanat,

0,08 g Diaza-bicyclo [2.2.2] octan in

30 ml 1,2-Dimethoxy-ethan.

Die Ausbeute beträgt 17,0 g, 94 % der Theorie.

Das Polymer zeigt folgende Analysenwerte:

| | |
|---|---|
| OH-Zahl (bestimmt nach DIN 53240): | 315 |
| Si-Gehalt (Elementaranalyse): | 13,9 % |

Herstellungsbeispiel 8

Die Darstellung des polymeren Bindemittels erfolgt analog zu der in Herstellungsbeispiel 4 angegebenen Art und Weise.

Folgende Rezepturbestandteile werden verwendet:

10 g Tannin (Gerbsäure; Riedel-de Haën)

12 g 2-(Pentamethyldisilanyl)-ethylisocyanat,

0,2 g Diaza-bicyclo[2.2.2]octan in

40 ml 1,2-Dimethoxy-ethan.

Man läßt die Polymerlösung langsam in eine Mischung aus 800 ml Wasser und 20 ml 3 n-Salzsäure einlaufen. Für eine gleichmäßige Ausfällung ist die Anwendung eines Hochgeschwindigkeitsrührwerkes (Fabrikat IKA-Rührwerk RE 166) vorteilhaft.

Das ausgefällte Polymer wird mit Hilfe einer Glassinternutsche abgesaugt und im Vakuumtrockenschrank 6 h bei 90° C getrocknet. Die Ausbeute beträgt 21,8 g (99 % der Theorie).

Das Polymer zeigt folgenden Analysenwert:

| | |
|---|---|
| Si-Gehalt (Elementaranalyse): | 15,0 % |

Herstellungsbeispiel 9:

Das folgende Beispiel zeigt wiederum eine Möglichkeit auf, das Bindemittel neben mit dem Silylierungsreagenz auch mit einem Pfropfungsmittel umzusetzen. In diesem Falle wird zuerst gepfropft und anschließend silyliert.

Die Darstellung des polymeren Bindemittels erfolgt analog zu der in Herstellungsbeispiel 5 angegebenen Art und Weise.

Folgende Rezepturbestandteile werden für den Pfropfungsschritt verwendet:

10 g Polyvinylphenol; charakterisiert durch ein Gewichtsmittel des Molekulargewichtes von $\overline{M}_w$ = 4.000

3,7 g 2-Ethoxy-4-O-(2,3-epoxypropyl)-1,3-benzdioxol,

0,1 g Aza-bicyclo[2.2.2]octan (Chinuclidin) in

30 ml 2-Methyl-tetrahydrofuran.

Folgendes Reagenz wurde für den Silylierungsschritt verwendet:

5 g Tris(trimethylsilyl)silanyl-$\beta$-ethylisocyanat.

Man läßt die Polymerlösung langsam in eine Mischung aus 800 ml Wasser, 100 ml Tetrahydrofuran und 20 ml 36 %ige Salzsäure einlaufen. Für eine gleichmäßige Ausfällung ist die Anwendung eines Hochgeschwindigkeitsrührwerkes (Fabrikat IKA-Rührwerk RE 166) vorteilhaft.

Das ausgefällte Polymer wird mit Hilfe einer Glassinternutsche abgesaugt und im Vakuumtrockenschrank 6 h bei 90° C getrocknet. Die Ausbeute beträgt 17 g (95 % der Theorie).

Das Polymer zeigt folgenden Analysenwert:

| | |
|---|---|
| Si-Gehalt (Elementaranalyse): | 9,9 % |

Herstellungsbeispiel 10:

In einen 100 ml Kolben werden unter Argon-Atmosphäre nacheinander folgende Substanzen eingewogen:
10 g eines Kondensationsproduktes stöchiometrischer Mengen Pyrogallol und Aceton mit einem Gewichtsmittel des Molekulargewichts von $\overline{M}_w$ = 1.470,
10 g 4-(2-Pentamethyldisilanyl-ethyl)-O-2,3-epoxypropyl-phenol,
0,1 g Diaza-bicyclo[2.2.2]octan in
100 ml 1,2-Dimethoxy-ethan
Durch Rühren bei Raumtemperatur entsteht nach kurzer Zeit eine homogene Lösung.

Anschließend wird der Kolben 6 h bei 85° C thermostatisiert. Das Bindemittel wird auf folgende Art und Weise isoliert: Man läßt die Polymerlösung langsam in eine Mischung aus 100 ml Methanol, 700 ml Wasser und 20 ml 3 n-Salzsäure einlaufen. Für eine gleichmäßige Ausfällung ist die Anwendung eines Hochgeschwindigkeitsrührwerkes (Fabrikat IKA-Rührwerk RE 166) vorteilhaft.

Das ausgefällte Polymer wird mit Hilfe einer Glassinternutsche abgesaugt und im Vakuumtrockenschrank 6 h bei 90° C getrocknet. Die Ausbeute beträgt 19 g (95 % der Theorie).

Das Polymer zeigt folgenden Analysenwert:

| | |
|---|---|
| Si-Gehalt (Elementaranalyse): | 9,0 % |

Herstellungsbeispiel 11:

In einen 100 ml Kolben werden unter Argon-Atmosphäre nacheinander folgende Substanzen eingewogen:
10 g modifizierter Polyvinylalkohol wie in US-A-4,374,193, Beispiel 1, beschrieben,
12 g (2,3)-endo-7-anti-Pentamethyldisilanylbicyclo[2.2.1]hept-5-en-2,3-dicarbonsäureanhydrid in
50 ml 1,2-Dimethoxy-ethan.

Durch Rühren bei 50° C entsteht nach kurzer Zeit eine homogene Lösung.

Anschließend fügt man

0,5 g Triethylamin

zu und thermostatisiert für 12 h bei 80° C.

Zur Aufarbeitung des Bindemittels läßt man die Polymerlösung langsam in 800 ml Wasser einlaufen. Für eine gleichmäßige Ausfällung ist die Anwendung eines Hochgeschwindigkeitsrührwerkes (Fabrikat IKA-Rührwerk RE 166) vorteilhaft. Das ausgefällte Polymer wird mit Hilfe einer Glassinternutsche abgesaugt und im Vakuumtrockenschrank 6 h bei 90° C getrocknet. Die Ausbeute beträgt 21,0 g (95 % der Theorie).

Das Polymer zeigt folgenden Analysewert:

| | |
|---|---|
| Si-Gehalt (Elementaranalyse): | 10,0 % |

Herstellungsbeispiel 12:

Das folgende Beispiel zeigt ein Bindemittel, das mit zwei unterschiedlichen Silanylverbindungen silyliert wurde.

In einen 100 ml Kolben werden unter Argon-Atmosphäre nacheinander folgende Substanzen eingewogen:
10 g Polyvinylphenol, charakterisiert durch ein Gewichtsmittel des Molekulargewichts von $\overline{M}_w$ = 4.000

7 g 4-(2-Pentamethyldisilanyl-ethyl)-O-2,3-epoxypropyl-phenol,
0,05 g Diaza-bicyclo[2.2.2]octan in
40 ml 1,2-Dimethoxy-ethan.

Man thermostatisiert für 6 h bei 85° C unter Rühren. Anschließend fügt man 3 g 2-(Pentamethyldisilanyl)-β-propio-lacton zu und thermostatisiert für 36 h bei 85° C.

Zur Aufarbeitung des Bindemittels läßt man die Polymerlösung langsam in 800 ml Wasser einlaufen. Die weitere Aufarbeitung erfolgt auf die Art und Weise, wie in Herstellungsbeispiel 11 beschrieben.

Die Ausbeute beträgt 19,2 g. Das Polymer zeigt folgenden Analysenwert:

| | |
|---|---|
| Si-Gehalt (Elementaranalyse): | 10,1 % |

Herstellungsbeispiel 13

In einen 100 ml Kolben werden unter Argon-Atmosphäre nacheinander folgende Substanzen eingewogen:
10 g Copolymer aus Brenzcatechin-monomethacrylat und Hydroxymethacrylat wie in der DE-A-35 28 929 beschrieben.
6 g Bis(2-Pentamethyldisilanylethyl)-carbodiimid
30 ml Propylenglykolmonomethyletheracetat (PGMEA)
Man thermostatisiert für 6 h bei 60° C unter magnetischem Rühren. Zur Aufarbeitung des Bindemittels läßt man die Polymerlösung langsam in 800 ml Hexan einlaufen. Das ausgefällte Polymer wird abgesaugt und im Vakuumtrockenschrank 12 h bei 90° C getrocknet.

Die Ausbeute beträgt 15,5 g (97 % der Theorie). Das Polymer zeigt folgenden Analysenwert:

| | |
|---|---|
| Si-Gehalt (Elementaranalyse): | 11,2 % |

Herstellungsbeispiel 14:

Folgende Rezepturbestandteile werden für die Pfropfung bei gleichzeitiger Anwendung eines Silylierungsreagenz eingewogen:
10 g eines Kresol-Formaldehyd-Novolaks mit einem Erweichungspunkt von 147 bis 150° C,
2 g N-[2-(Pentamethyldisilanyl)-ethyl-O-2,3-epoxypropyl]-carbaminsäure,
3,6 g Triglyceringlycidether und
0,08 g Diaza-bicyclo[2.2.2]octan in
30 ml 2-Methyl-tetrahydrofuran.

Man thermostatisiert für 6 h bei 85° C unter magnetischem Rühren. Anschließend wird für die zweite Silylierung folgendes Reagenz verwendet:
7 g Tris(trimethylsilyl)silanyl-β-ethylisocyanat.

Man thermostatisiert für weitere 6 h hei 60° C unter magnetischem Rühren. Die Ausfällung des Polymers erfolgt auf die gleiche Weise, wie in Herstellungsbeispiel 4 beschrieben.

Die Ausbeute beträgt 21,0 g (93 % der Theorie).

| | |
|---|---|
| Si-Gehalt (Elementaranalyse): | 12,4 % |

Herstellungsbeispiel 15:

Folgende Rezepturbestandteile werden verwendet:
10 g Tannin (Gerbsäure; Riedel-de-Haën)
18 g N-(3-Methyl-4-isocyanato)-phenyl-O-(2-pentamethyldisilanylethyl)-carbaminsäure und
0,2 g Diaza-bicyclo[2.2.2]octan in
50 ml 1,2-Dimethoxy-ethan.

Die Umsetzung und Aufarbeitung erfolgen analog zu der in Herstellungsbeispiel 8 angegebenen Art und Weise.

Die Ausbeute beträgt 27,5 g (98 % der Theorie).

| | |
|---|---|
| Si-Gehalt (Elementaranalyse): | 10,0 % |

Herstellungsbeispiel 16:

Folgende Rezepturbestandteile werden für den Silylierungsschritt verwendet:
10 g Polyvinylphenol charakterisiert durch ein Gewichtsmittel des Molekulargewichts von $\overline{M}_w$ = 4.000,
15 g 4-(2-Pentamethyldisilanylethyl)-O-2,3-epoxypropyl-phenol
0,1 g Diaza-bicyclo[2.2.2]octan in
100 ml 2-Methyl-tetrahydrofuran.

Man thermostatisiert für 12 h bei 85° C unter magnetischem Rühren. Anschließend wird für den Pfropfungsschritt folgendes Reagenz verwendet:
3 g des Umsetzungsproduktes aus 2-Ethoxy-4-hydroxy-1,3-benzdioxol und Toluylen-2,4-diisocyanat.

Man thermostatisiert für 6 h bei 80° C unter magnetischem Rühren. Die Aufarbeitung erfolgt analog zu der in Herstellungsbeispiel 8 angegebenen Art und Weise.

Die Ausbeute beträgt 26,5 g (96 % der Theorie).

| | |
|---|---|
| Si-Gehalt (Elementaranalyse): | 9,7 % |

Herstellungsbeispiel 17:

In einen 250 ml Kolben werden unter Argon-Atmosphäre nacheinander folgende Substanzen eingewogen:
10 g Kondensationsproduktes aus 3-Hydroxybenzaldehyd und Polyvinylalkohol dessen Gewichtsmittel des Molekulargewichts $\overline{M}_w$ = 530 beträgt (Literatur zur Herstellung dieses Kondensationsproduktes: T. Motoyama, S. Okamura in Kobunshi Kagaku 7, 265 (1950)),und bei dem weniger als die Hälfte aller Hydroxylgruppen acetalisch gebunden sind,
20g 2-(Pentamethyldisilanyl)-essigsäureethylester und
1 g Titansäuretetraethylester in
100 ml Dimethylformamid.

Die Mischung wird 24 h bei 100° C thermostatisiert. Zur Aufarbeitung des Bindemittels läßt man die Polymerlösung langsam in 1.000 ml Hexan einlaufen. Für eine gleichmäßige Ausfällung ist die Anwendung eines Hochgeschwindigkeitsrührwerkes (Fabrikat IKA-Rührwerk RE 166) vorteilhaft. Das ausgefällte Polymer wird abgesaugt und bei 60° C 24 h im Vakuumtrockenschrank getrocknet. Man erhält 16 g Polymer mit einem Siliciumgehalt von 9,5 % (bestimmt durch Elementaranalyse).

Herstellungsbeispiel 18 (Vergleichsbeispiel):

Die Darstellung und Aufarbeitung des polymeren Bindemittels erfolgt analog in der in Herstellungsbeispiel 4 angegebenen Art und Weise.

Folgende Rezepturbestandteile werden verwendet:
10 g eines Kresol-Formaldehyd-Novolaks mit einem Erweichungsbereich von 147 bis 150° C,
3,6 g 2-(Trimethylsilyl)-ethylisocyanat,
0,05 g Diaza-bicyclo[2.2.2]octan in
20 ml 1,2-Dimethoxy-ethan.

Die Ausbeute beträgt 12,8 g (94 % der Theorie). Das Polymer zeigt folgende Analysenwerte:

| | |
|---|---|
| OH-Zahl (bestimmt nach DIN 53240): | 200 |
| Si-Gehalt (Elementaranalyse): | 5,1 % |
| Glastemperatur: | 100 ° C |

Herstellungsbeispiel 19 (Vergleichsbeispiel):

Die Darstellung und Aufarbeitung des polymeren Bindemittels erfolgt analog in der in Herstellungsbeispiel 5 angegebenen Art und Weise.

Folgende Rezepturbestandteile werden für den Pfropfungsschritt verwendet:
10 g eines Kresol-Formaldehyd-Novolaks mit einem Erweichungsbereich von 105 bis 120 ° C,
0,92 g 2,3-Epoxy-propan-1-ol (Glycidol),
0,05 g Diaza-bicyclo[2.2.2]octan in
30 ml Diethylenglykoldimethylether.

Folgendes Reagenz wurde für den Silylierungsschritt verwendet:
3,6 g 2-(Trimethylsilanyl)-ethylisocyanat.

Die Ausbeute beträgt 13,1 g (90 % der Theorie). Das Polymer zeigt folgende Analysenwerte:

| | |
|---|---|
| OH-Zahl (bestimmt nach DIN 53240): | 230 |
| Si-Gehalt (Elementaranalyse): | 4,7 % |
| Glastemperatur: | 100 ° C |

Herstellungsbeispiel 20 (Vergleichsbeispiel):

Folgende Rezepturbestandteile werden verwendet:
10 g Tannin (Gerbsäure; Riedel-de-Haën)
18 g N-(3-Methyl-4-isocyanato)phenyl-O-(2-trimethylsilyl)ethyl-carbaminsäure und
0,2 g Diaza-bicyclo[2.2.2]octan in
50 ml 1,2-Dimethoxy-ethan.

Die Umsetzung und Aufarbeitung erfolgen analog zu der in Herstellungsbeispiel 15 angegebenen Art und Weise.

Die Ausbeute beträgt 27 g (96 % der Theorie).

| | |
|---|---|
| Si-Gehalt (Elementaranalyse): | 6,0 % |

Herstellungsbeispiel 21 (Vergleichsbeispiel):

Folgende Rezepturbestandteile werden verwendet:
10 g modifizierter Polyvinylalkohol wie in US-A-4,374,193, Beispiel 1, beschrieben,
12 g (2,3)-endo-7-anti-Trimethylsilyl-bicyclo[2.2.1]hept-5-en-2,3-dicarbonsäureanhydrid in
50 ml 1,2-Dimethoxy-ethan und
0,5 g Triethylamin.

Die Umsetzung und Aufarbeitung erfolgen analog zu der in Herstellungsbeispiel 11 angegebenen Art und Weise.

Die Ausbeute beträgt 21 g (95 % der Theorie).

| | |
|---|---|
| Si-Gehalt (Elementaranalyse): | 6,3 % |

Im folgenden werden die mit den beschriebenen Bindemitteln hergestellten Photoresists zusammengestellt. In den Beispielen verhalten sich Gewichtsteile (Gt) zu Volumenteilen (Vt) wie g : $cm^3$.

Anwendungsbeispiel 1:

Eine Photoresistlösung wird durch Mischen folgender Bestandteile hergestellt:
11,7 Gt des Bindemittels aus Herstellungsbeispiel 4 und
3,5 Gt eines Kondensationsproduktes aus 1,2-Naphthochinon-2-diazid-5-sulfonylchlorid und 2,3,4-Trihydroxybenzochinon in
29,0 Gt Ethylglykolacetat,
3,1 Gt Butylacetat und
3,1 Gt Xylol.

Die entstehende klare Lösung mit einem Feststoffgehalt von 30 % filtriert man durch ein 0,2 µm-Filter (Millipore).

Die Resistlösung wird auf käufliche, wie üblich polierte und durch Oxidation mit einer 0,2 µm dicken Siliciumdioxid-Schicht versehene Silicium-Scheiben (Wafer) aufgeschleudert. Durch Variation der Umdrehungsgeschwindigkeit können die Schichtdicken auf ca. 1 µm eingestellt werden.

Die so beschichteten Scheiben werden 30 Minuten in einem Umlufttrockenofen bei 90° C getrocknet. Nach dem Abkühlen und Konditionieren auf ein definiertes Raumklima von 23° C und 40-50 % relativer Luftfeuchte werden die Wafer mit Hilfe eines Projektionsbelichtungsgeräts (Canon FPA-1550) durch eine handelsübliche Maske bildmäßig belichtet.

Die Entwicklung erfolgt durch Tauchen des belichteten Aufzeichungsmaterials in eine 1 n gepufferte Natronlauge mit einem Zusatz von 1 % Netzmittel vom Typ eines alkoxylierten Phenols.

Das erhaltene positive Resistbild wird dem reaktiven Sauerstoff-Ionenätzen unter Anwendung folgender Bedingungen unterworfen:

| | |
|---|---|
| Sauerstoff-Strömungsgeschwindigkeit: | 20 cm/Min |
| Sauerstoff-Druck: | 50 mTorr |
| eingestrahlte Hochfrequenzleistung: | 200 W |

Danach erfolgt eine Schichtdickenmessung mit einem Schichtdickenmeßgerät Fabrikat Sloan Dektak II.

Nach 10 Minuten Ätzzeit hat sich die Schichtdicke von anfänglich 1.000 Nanometer auf 890 Nanometer vermindert.

Als Vergleichsstandard wird ein Film aus einem Kresol-Novolak gleichen Erweichungsbereichs wie oben angegeben unter den gleichen Bedingungen geätzt. Bei einer Schichtdicke anfänglich von 2.000 Nanometer hat dieser Film unter den gleichen Ätzbedingungen nach 10 Minuten eine Restschichtdicke von 800 Nanometer.

Das differentielle Ätzratenverhältnis soll definiert sein durch folgende Gleichung:

$$\frac{\text{Ätzrate Novolak [Nanometer/Minute]}}{\text{Ätzrate Siliciumhaltiger Resist [Nanometer/Minute]}}$$

Das differentielle Ätzratenverhältnis nach 10 Minuten Ätzzeit beträgt 10,9.

Weiterhin wird unter den obengenannten Bedingungen ein positives Resistbild dem reaktiven Ionenätzen mit Sauerstoff über eine Zeitdauer von 20 Minuten unterworfen.

Als Vergleichsstandard dient ebenfalls ein Film aus einem Kresol-Novolak des oben beschriebenen Typs. Das differentielle Ätzratenverhältnis nach 20 Minuten Ätzzeit beträgt 15,0.

In einem weiteren Experiment wird ein Wafer mit einem Kresol-Formaldehyd-Harz mit einem Erweichungsbereich von 147-150° C schleuderbeschichtet, so daß ein ca. 2,0 µm dicker Film resultiert, der als Planarisierungsschicht dient.

Die so beschichtete Scheibe wird 30 Minuten in einem Umlufttrockenofen bei 90° C getrocknet. Anschließend erwärmt man den Wafer für 15 Minuten auf 210° C im Umluftofen. Man läßt abkühlen, und schleuderbeschichtet den Wafer mit der oben angegebenen Resist-Lösung, die man so verdünnt, daß bei Variation der Schleuderdrehzahl eine Resistschichtdicke von ca. 0,5 µm nach der Trocknung resultiert. Anschließend wird der Wafer in einem Umluftofen bei 90° C für 30 Minuten getrocknet. Das erhaltene positive Resistbild wird dem reaktiven Sauerstoff-Ionenätzen unter Anwendung der oben angeführten Bedingungen während einer Zeit von 20 Minuten unterworfen. Dabei wird das positive Resistmuster auf den darunterliegenden Novolak genau übertragen.

Anwendungsbeispiel 2 (Vergleichsbeispiel):

Eine Photoresistlösung wird durch Mischen folgender Bestandteile hergestellt:
11,7 Gt des Bindemittels aus Herstellungsbeispiel 18 (Vergleichsbeispiel)
3,5 Gt eines Kondensationsproduktes aus 1,2-Naphthochinon-2-diazid-5-sulfonylchlorid und 2,3,4-Trihydroxybenzochinon in
29,0 Gt Ethylglykolacetat,
3,1 Gt Butylacetat und
3,1 Gt Xylol.

Unter Anwendung der in Anwendungsbeispiel 1 angegebenen Verfahrensschritte erhält man ein positives Resistbild.

Das so erhaltene positive Resistbild wird dem reaktiven Sauerstoff-Ionenätzen unter Anwendung der in Anwendungsbeispiel 1 angegebenen Ätzbedingungen unterworfen. Das differentielle Ätzratenverhältnis nach 10 Minuten Ätzzeit beträgt 2,0. Das differentielle Ätzratenverhältnis nach 20 Minuten Ätzzeit beträgt 2,2.

In einem weiteren Experiment wird ein Wafer mit einem Kresol-Formaldehyd-Harz mit einem Erweichungsbereich von 147 bis 150° C wie in Anwendungsbeispiel 1 beschrieben, schleuderbeschichtet, so daß ein ca. 2,0 µm dicker Film resultiert. Die so beschichtete Scheibe wird 30 Minuten in einem Umlufttrockenofen bei 90° C getrocknet. Anschließend erwärmt man den Wafer für 15 Minuten auf 210° C im Umluftofen. Man läßt abkühlen, und schleuderbeschichtet den Wafer mit der oben angegebenen Resist-Lösung, die man so verdünnt, daß bei Variation der Schleuderdrehzahl eine Resistschichtdicke von ca. 0,5 µm nach der Trocknung resultiert. Anschließend wird der Wafer in einem Umluftofen bei 90° C für 30 Minuten getrocknet. Das erhaltene positive Resistbild wird dem reaktiven Sauerstoff-Ionenätzen unter Anwendung der oben angeführten Bedingungen während einer Zeit von 20 Minuten unterworfen. Nach 20 Minuten Ätzzeit zeigt das ursprünglich positive Resist-Muster starke Erosionserscheinungen. Eine genaue Strukturübertragung ist nicht möglich.

Anwendungsbeispiel 3:

Eine Photoresistlösung wird durch Mischen folgender Bestandteile hergestellt:
20,0 Gt des Bindesmittels aus Herstellungsbeispiel 5
3,5 Gt eines Kondensationsproduktes aus 1,2-Naphthochinon-2-diazid-4-sulfonylchlorid und 2,3,4-Trihydroxybenzochinon in
100,0 Gt Propylenglykol-1-monomethylether-2-acetat.

Man erhält ein positives Resistbild, sofern gemäß Anwendungsbeispiel 1 vorgegangen wird. Das so erhaltene positive Resistbild wird dem reaktiven Sauerstoff-Ionenätzen bei den in Anwendungsbeispiel 1 angegebenen Ätzbedingungen unterworfen. Das differentielle Ätzratenverhältnis nach 10 Minuten und 20 Minuten Ätzzeit gegenüber dem in Anwendungsbeispiel 1 angeführten Kresol-Novolak ist jeweils deutlich höher als 10.

Anwendungsbeispiel 4 (Vergleichsbeispiel):

Eine Photoresistlösung wird durch Mischen folgender Bestandteile hergestellt:
20,0 Gt des Bindemittels aus Herstellungsbeispiel 19, und
3,5 Gt eines Kondensationsproduktes aus 1,2-Naphthochinon-2-diazid-4-sulfonylchlorid und 2,3,4-Trihydroxybenzochinon in
100,0 Gt Propylenglykol-1-monomethylether-2-acetat.

Man erhält ein positives Resistbild, nachdem gemäß Anwendungsbeispiel 1 vorgegangen wurde. Das so erhaltene positive Resistbild wird dem reaktiven Sauerstoff-Ionenätzen unter Anwendung der in Anwendungsbeispiel 1 angegebenen Ätzbedingungen unterworfen. Das differentielle Ätzratenverhältnis nach 10 Minuten und 20 Minuten Ätzzeit gegenüber dem in Anwendungsbeispiel 1 angeführten Kresol-Novolak ist jeweils kleiner als 5.

Anwendungsbeispiel 5:

Eine Photoresistlösung wird durch Mischen folgender Bestandteile hergestellt:
20,0 Gt des Bindemittels aus Herstellungsbeispiel 6, und
5,0 Gt eines Kondensationsproduktes aus 1,2-Naphthochinon-2-diazid-5-sulfonylchlorid und 2,3,4-Trihydroxybenzochinon in

100,0 Gt Propylenglykol-1-monomethylether-2-acetat.

Man erhält ein positives Resistbild, nachdem gemäß Anwendungsbeispiel 1 vorgegangen wurde. Das so erhaltene positive Resistbild wird dem reaktiven Sauerstoff-Ionenätzen unter Anwendung der in Anwendungsbeispiel 1 angegebenen Ätzbedingungen unterworfen. Das differentielle Ätzratenverhältnis nach 10 Minuten Ätzzeit beträgt 37. Das differentielle Ätzratenverhältnis nach 20 Minuten Ätzzeit beträgt 33.

Anwendungsbeispiel 6:

Eine Photoresistlösung wird durch Mischen folgender Bestandteile hergestellt:
20,0 Gt des Bindemittels aus Herstellungsbeispiel 6, und
2,5 Gt eines Kondensationsproduktes aus 1,2-Naphthochinon-2-diazid-5-sulfonylchlorid und 2,3,4-Trihydroxybenzochinon und
2,5 Gt eines Kondensationsproduktes aus 1,2-Naphthochinon-2-diazid-4-sulfonylchlorid und 2,3,4-Trihydroxybenzochinon in
100,0 Gt Propylenglykol-1-monomethylether-2-acetat.

Man erhält ein positives Resistbild unter Anwendung der in Anwendungsbeispiel 1 angegebenen Verfahrensschritte. Dabei wird als Entwicklungslösung eine gepufferte 0.1 n Natronlauge verwendet. Das so erhaltene positive Resistbild wird dem reaktiven Sauerstoff-Ionenätzen unter Anwendung der in Anwendungsbeispiel 1 angegebenen Ätzbedingungen unterworfen. Das differentielle Ätzratenverhältnis nach 10 Minuten und 20 Minuten Ätzzeit gegenüber dem in Anwendungsbeispiel 1 angeführten Kresol-Novolak ist jeweils höher als 30.

Anwendungsbeispiel 7:

Die Mischbarkeit und Verträglichkeit der erfindungsgemäßen Bindemittel mit herkömmlichen Novolak-Harzen verdeutlicht dieses Beispiel.

Eine Photoresistlösung wird durch Mischen folgender Bestandteile hergestellt:
14,0 Gt des Bindemittels aus Herstellungsbeispiel 8,
6,0 Gt eines Kresol-Formaldehyd-Novolaks mit einer Glastemperatur von 115° C, und
5,0 Gt eines Kondensationsproduktes aus einer Mischung im Molverhältnis 1:1 von 1,2-Naphthochinon-2-diazid-5-sulfonylchlorid und 1,2-Naphthochinon-2-diazid-4-sulfonylchlorid mit 2,3,4-Trihydroxybenzochinon in
100,0 Gt Propylenglykol-1-monomethylether-2-acetat.

Man erhält ein positives Resistbild, sofern gemäß den in Anwendungsbeispiel 1 angegebenen Verfahrensschritten vorgegangen wird. Dabei wird als Entwicklungslösung eine gepufferte 0.1 n Natronlauge mit einem nichtionischen Tensid, z.B. einem Nonylphenolpolyglykolether verwendet. Das so erhaltene positive Resistbild wird dem reaktiven Sauerstoff-Ionenätzen gemäß den in Anwendungsbeispiel 1 angegebenen Ätzbedingungen unterworfen. Das differentielle Ätzratenverhältnis nach 10 Minuten und 20 Minuten Ätzzeit gegenüber dem in Anwendungsbeispiel 1 angeführten Kresol-Novolak ist jeweils höher als 10.

Anwendungsbeispiel 8:

Eine Photoresistlösung wird durch Mischen folgender Bestandteile hergestellt:
20,0 Gt des Bindemittels aus Herstellungsbeispiel 6 und
4,0 Gt 2,6-Bis-(4,4'-azidobenzal)-4-methylcyclohexan in
40,0 Gt Propylenglykol-1-monomethylether-2-acetat und
40,0 Gt Xylol.

Mit dieser Resistlösung wird ein negatives Resistbild folgendermaßen hergestellt: Ein Wafer wird, wie in Anwendungsbeispiel 1 beschrieben, schleuderbeschichtet und 30 Minuten in einem Umlufttrockenofen bei 80° C getrocknet. Nach Abkühlen wird der Wafer mit Hilfe eines Kontaktbelichters (K. Süss MJB-3) durch eine handelsübliche Maske belichtet. Die Entfernung der unbelichteten Bildstellen erfolgt durch Tauchen in Methylisobutylketon und anschließend Spülen mit Isopropanol.

Das so erhaltene negative Resistbild wird dem reaktiven Sauerstoff-Ionenätzen gemäß Anwendungsbeispiel 1 unterworfen. Das differentielle Ätzratenverhältnis nach 10 Minuten und 20 Minuten Ätzzeit gegenüber dem in Anwendungsbeispiel 1 angeführten Kresol-Novolak ist jeweils höher als 20.

Anwendungsbeipiel 9:

Eine Photoresistlösung wird durch Mischen folgender Bestandteile hergestellt:
20,0 Gt des Bindemittels aus Herstellungsbeispiel 6
5,5 Gt eines Kondensationsproduktes aus 2-Ethylbutyraldehyd und Triethylenglykol mit einem Gewichtsmittel des Molekulargewichts von $\overline{M}_w$ = 1.000 und
0,5 Gt 2,4-Bis-(trichlormethyl)-6-p-methoxystyryl-s-triazin in
100,0 Gt Propylenglykol-1-monomethylether-2-acetat.

Man erhält ein positives Resistbild unter Anwendung der in Anwendungsbeispiel 1 angegebenen Verfahrensschritte. Die Entfernung der belichteten Bildstellen erfolgt durch Tauchen in eine gepufferte 0.5 n Natronlauge mit einem Zusatz von 0,5 % Netzmittel vom Typ eines alkoxylierten Phenols. Das so erhaltene positive Resistbild wird dem reaktiven Sauerstoff-Ionenätzen gemäß Anwendungsbeispiel 1 unterworfen. Das differentielle Ätzratenverhältnis nach 10 Minuten und 20 Minuten Ätzzeit gegenüber dem in Anwendungsbeispiel 1 angeführten Kresol-Novolak ist jeweils höher als 15.

## Patentansprüche

**1.** In wäßrigem Alkali lösliche, zumindest quellbare, polymere Bindemittel mit seitenständigen aliphatischen und/oder aromatischen Hydroxylgruppen, die modifiziert sind durch Umsetzung mit einem Silicium enthaltenden Reagens der allgemeinen Formel I

$(A - B_n -)_m C$ (I)

oder durch Umsetzung mit einem Pfropfungsreagens der allgemeinen Formel II

$(D -)_o(E -)_p B - C$ (II),

das seinerseits Hydroxylgruppen enthält, und dem Silicium enthaltenden Reagens der allgemeinen Formel I, worin

A — eine Silanylgruppe mit mindestens 2 miteinander verknüpften Siliciumatomen insgesamt, aber nicht mehr als 3 miteinander verknüpften Siliciumatomen in einer unverzweigten Kette aus Siliciumatomen,

B — eine Brückengruppe der allgemeinen Formel IV

$-(b_1)_r - (X) - (b_2)_s-$ (IV)

worin

$b_1$ — $(C_1-C_4)$Alkylen ist oder eine aus einem Alkdienylen mit einem Dienophil in einer 1,4-Cycloaddition (Diels-Alder-Reaktion) entstehende Gruppe, die mindestens eine C-C-Doppelbindung aufweist,

X — eine Einfachbindung, -O-, -S-, $-SO_2-$, -NH-, $-NR^1-$, -O-CO-, -NH-CO- oder -NH-CO-O-, worin $R^1$ ein $(C_1-C_3)$Alkyl ist, und

$b_2$ — Arylen oder Cycloalkylen ist, sowie

r,s — unabhängig voneinander 0 oder 1 sind,

C — eine funktionelle Gruppe, die mit den Hydroxylgruppen des Bindemittels und/oder der Gruppen D und/oder E unter Ausbildung einer kovalenten Bindung reagieren kann,

D — der Rest eines ein- oder mehrwertigen aliphatischen bzw. cycloaliphatischen Alkohols und

E — der Rest eines ein- oder mehrwertigen aromatischen Alkohols sowie

m — 1 oder 2 und

n, o, und p — unabhängig voneinander 0 oder 1 bedeuten,

und einen Siliciumgehalt von 7 bis 30 Gew.-% aufweisen.

**2.** Bindemittel gemäß Anspruch 1, dadurch gekennzeichnet, daß es als Gruppen A Silanylgruppen der allgemeinen Formel III

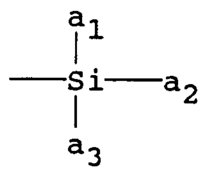

(III)

enthält, worin

$a_1$-$a_3$ R, -$SiR_3$ und -$Si_2R_5$ sind, wobei R für ($C_1$-$C_3$)Alkyl, insbesondere Methyl, und/oder Aryl, insbesondere Phenyl, steht, mit der Maßgabe, daß mindestens einer der Reste $a_1$ bis $a_3$ -$SiR_3$ und nicht mehr als einer dieser Reste -$Si_2R_5$ ist.

**3.** Bindemittel gemäß Anspruch 2, dadurch gekennzeichnet, daß es Silanylgruppen enthält, die zwei oder drei Siliciumatome enthalten und/oder die als Rest R ($C_1$-$C_3$)Alkyl, insbesondere Methyl, aufweisen.

**4.** Bindemittel gemäß Anspruch 1, dadurch gekennzeichnet, daß die funktionelle Gruppe C eine Epoxygruppe, die gegebenenfalls über eine Alkylenoder Oxaethanogruppe gebunden ist, eine Aziridino-und Carboxylgruppe oder deren Derivat, wie Ester, Carbonsäurechlorid, Carbonsäureamid, Anhydrid, Lacton und Lactam, aber auch eine Isocyanat- oder Carbodiimidgruppe ist.

**5.** Bindemittel gemäß Anspruch 1, dadurch gekennzeichnet, daß die Gruppen D sich ableiten von ein-bis sechswertigen aliphatischen Alkoholen, die gegebenenfalls mit weiteren Alkoholen, insbesondere solchen mit gleicher Wertigkeit, verethert sind.

**6.** Bindemittel gemäß Anspruch 1, dadurch gekennzeichnet, daß die Gruppen E sich ableiten von ein-bis fünfwertigen, insbesondere von drei- bis fünfwertigen, aromatischen Alkoholen.

**7.** Verfahren zur Herstellung eines Bindemittels gemäß einem oder mehreren der Ansprüche 1 bis 6, dadurch gekennzeichnet, daß das, unmodifizierte Bindemittel mit dem Silylierungsreagens der allgemeinen Formel I in einem aprotischen Lösemittel umgesetzt und, insbesondere wenn die Gruppe C eine Isocyanatgruppe ist, die Umsetzung in Gegenwart eines Katalysators ausgeführt wird.

**8.** Verfahren gemäß Anspruch 7, dadurch gekennzeichnet, daß das Bindemittel vor der Silylierung mit dem Pfropfungsreagens der allgemeinen Formel II in einem aprotischen Lösemittel bei einer Temperatur von 60 bis 90 °C umgesetzt wird.

**9.** Verfahren gemäß Anspruch 7, dadurch gekennzeichnet, daß das Bindemittel nach der Silylierung mit dem Pfropfungsreagens der allgemeinen Formel II in einem aprotischen Lösemittel bei einer Temperatur von über 60 °C umgesetzt wird.

**10.** Verfahren gemäß Anspruch 8 oder 9, dadurch gekennzeichnet, daß die Umsetzung in Gegenwart eines Katalysators ausgeführt wird.

**11.** Lichtempfindliches Gemisch, im wesentlichen bestehend aus einer lichtempfindlichen Verbindung bzw. einem lichtempfindlichen System und einem Bindemittel, dadurch gekennzeichnet, daß das Bindemittel ein Bindemittel gemäß einem oder mehreren der Ansprüche 1 bis 6 umfaßt.

**12.** Lichtempfindliches Gemisch gemäß Anspruch 11, dadurch gekennzeichnet, daß es als lichtempfindliche Verbindung ein o-Chinondiazid enthält und positiv arbeitend ist.

**13.** Lichtempfindliches Gemisch gemäß Anspruch 11, dadurch gekennzeichnet, daß es als lichtempfindliches System eine unter der Einwirkung von aktinischer Strahlung eine starke Säure bildende Verbindung und eine durch Säure spaltbare Verbindung enthält und positiv arbeitend ist.

**14.** Lichtempfindliches Gemisch gemäß Anspruch 11, dadurch gekennzeichnet, daß es als lichtempfindliche Verbindung eine aromatische Azidoverbindung enthält und negativ arbeitend ist.

**15.** Lichtempfindliches Aufzeichnungsmaterial, im wesentlichen bestehend aus einem Substrat, gegebenenfalls einer darauf aufgebrachten Planarisierungsschicht, und einer lichtempfindlichen Schicht, dadurch gekennzeichnet, daß die lichtempfindliche Schicht aus dem lichtempfindlichen Gemisch gemäß einem oder mehreren der Ansprüche 11 bis 14 besteht.

**16.** Lichtempfindliches Aufzeichnungsmaterial gemäß Anspruch 15, dadurch gekennzeichnet, daß sich die Planarisierungsschicht durch reaktives Ionenätzen entfernen läßt.

**17.** Lichtempfindliches Aufzeichnungsmaterial gemäß Anspruch 15 oder 16, dadurch gekennzeichnet, daß die Planarisierungsschicht aus einem Novolak-Harz, einem Polyimid, einem thermisch behandelten Positiv-Resist auf Novolak-Basis, einem Polystyrol, einem Poly[methyl-(meth)acrylat] oder einem Polyvinylacetat besteht.

**Claims**

**1.** Polymeric binders which are soluble, or at least swellable, in aqueous alkali and which have lateral aliphatic and/or aromatic hydroxyl groups modified by reaction with a silicon-containing reagent of the formula I

$(A - B_n -)_m C$ (I)

or by reaction with a grafting reagent of the formula II

$(D -)_o(E -)_p B - C$ (II)

which, for its part, contains hydroxyl groups, and with the silicon-containing reagent of the formula I, where

| | |
|---|---|
| A | denotes a silanyl group containing at least 2 silicon atoms in total linked to each other, but not more than 3 silicon atoms linked to each other in an unbranched chain of silicon atoms, |
| B | denotes a bridging group of the formula IV<br><br>$-(b_1)_r - (X) - (b_2)_s-$ (IV)<br><br>where |
| $b_1$ | is $(C_1-C_4)$ alkylene or a group which has been produced from an alkdienylene, in a 1,4-cycloaddition (Diels-Alder reaction) with a dienophile and which has at least one C-C double bond, |
| X | is a single bond, -O-, -S-, $-SO_2-$, -NH-, $-NR^1-$, -O-CO-, -NH-CO- or -NH-CO-O-, where $R^1$ is a $(C_1-C_3)$alkyl, and |
| $b_2$ | is arylene or cycloalkylene, and |
| r, s | are, independently of one another, 0 or 1, |
| C | denotes a functional group which may react with the hydroxyl groups of the binder and/or of the groups D and/or E to form a covalent bond, |
| D | denotes the radical of a mono- or polyhydric aliphatic or cycloaliphatic alcohol and |
| E | denotes the radical of a mono- or polyhydric aromatic alcohol and |
| m | denotes 1 or 2 and |
| n, o and p | denote, independently of one another, 0 or 1, |

and which have a silicon content of 7 to 30% by weight.

**2.** A binder as claimed in claim 1, characterized in that it contains as groups A silanyl groups of the formula III

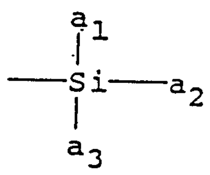

(III)

where

$a_1$-$a_3$ are R, $-SiR_3$ and $-Si_2R_5$, R being $(C_1$-$C_3)$alkyl, in particular methyl, and/or aryl, in particular phenyl, with the proviso that at least one of the radicals $a_1$ to $a_3$ is $-SiR_3$ and not more than one of said radicals is $-Si_2R_5$.

**3.** A binder as claimed in claim 2, characterized in that it contains silanyl groups which contain two or three silicon atoms and/or which contains $(C_1$-$C_3)$ alkyl, in particular methyl, as radical R.

**4.** A binder as claimed in claim 1, characterized in that the functional group C is an epoxy group which is optionally bound by an alkylene or oxaethano group, an aziridino and carboxyl group or its derivative, such as ester, carboxylic acid chloride, carboxylic acid amide, anhydride, lactone and lactam, or, alternatively, an isocyanate or carbodiimide group.

**5.** A binder as claimed in claim 1, characterized in that the groups D are derived from mono- to hexahydric aliphatic alcohols which are optionally etherified with further alcohols, in particular those with the same hydric index.

**6.** A binder as claimed in claim 1, characterized in that the groups E are derived from mono- to pentahydric, in particular from tri- to pentahydric, aromatic alcohols.

**7.** A process for preparing a binder as claimed in one or more of claims 1 to 6, characterized in that the unmodified binder is reacted with the silylating reagent of the formula I in an aprotic solvent and, in particular if the group C is an isocyanate group, the reaction is carried out in the presence of a catalyst.

**8.** The process as claimed in claim 7, characterized in that the binder is reacted, before the silylation, with the grafting reagent of the formula II in an aprotic solvent at a temperature of 60 to 90 °C.

**9.** The process as claimed in claim 7, characterized in that the binder is reacted, after the silylation, with the grafting reagent of the formula II in an aprotic solvent at a temperature of over 60 °C.

**10.** The process as claimed in claim 8 or 9, characterized in that the reaction is carried out in the presence of a catalyst.

**11.** A photosensitive mixture composed essentially of a photosensitive compound or a photosensitive system and a binder, characterized in that the binder comprises a binder as claimed in one or more of claims 1 to 6.

**12.** A photosensitive mixture as claimed in claim 11, characterized in that it contains as photosensitive compound an o-quinonediazide and is positive-working.

**13.** A photosensitive mixture as claimed in claim 11, characterized in that it contains as photosensitive system a compound forming a strong acid when exposed to actinic radiation and an acid-cleavable compound and is positive-working.

**14.** A photosensitive mixture as claimed in claim 11, characterized in that it contains as photosensitive compound an aromatic azido compound and is negative-working.

**15.** A photosensitive recording material, which is composed essentially of a substrate, optionally of a planarization layer deposited thereon, and of a photosensitive layer, characterized in that the photosensitive layer is composed of the photosensitive mixture as claimed in one or more of claims 11 to 14.

**16.** A photosensitive recording material as claimed in claim 15, characterized in that the planarization layer can be removed by reactive ion etching.

**17.** A photosensitive recording material as claimed in claim 15 or 16, wherein the planarization layer is composed of a novolak resin, a polyimide, a thermally treated, novolak-based positive resist, a polystyrene, a poly[methyl (meth)acrylate] or a polyvinyl acetate.

## Revendications

**1.** Liants polymères solubles ou au moins susceptibles de gonfler dans un alcali en solution aqueuse, et comportant des groupes hydroxy aliphatiques et/ou aromatiques latéraux qui sont modifiés par réaction avec un réactif contenant du silicium, de formule générale I

$(A\text{-}B_n\text{-})_mC$ (I)

ou par réaction avec un réactif de greffage de formule générale II

$(D\text{-})_o(E\text{-})_pB\text{-}C$ (II),

qui contient pour sa part des groupes hydroxy, et le réactif contenant du silicium, de formule générale I,
formules dans lesquelles

- A — représente un groupe silanyle comportant au total au moins 2 atomes de silicium liés l'un à l'autre, mais pas plus de 3 atomes de silicium liés les uns aux autres en une chaîne non ramifiée d'atomes de silicium;
- B — représente un groupe pontant de formule générale IV

  $-(b_1)_r\text{-}(X)\text{-}(b_2)_s\text{-}$ (IV)

  dans laquelle
- $b_1$ — est un groupe alkylène en $C_1$-$C_4$ ou un groupement formé à partir d'un groupe alkdiénylène avec un diénophile dans une 1,4-cycloaddition (réaction de Diels-Alder), qui comporte au moins une double liaison C-C,
- X — est une simple liaison,-O-, -S-, $-SO_2-$, -NH-, $-NR^1-$, -O-CO-, -NH-CO- ou -NH-CO-O-, $R^1$ étant un groupe alkyle en $C_1$-$C_3$, et
- $b_2$ — est un groupe arylène ou cycloalkylène, et
- r, s, — indépendamment l'un de l'autre, sont 0 ou 1;
- C — représente un groupe fonctionnel qui peut réagir avec les groupes hydroxy du liant et/ou des groupes D et/ou E, avec formation d'une liaison covalente;
- D — représente le reste d'un monoalcool ou polyol aliphatique ou cycloaliphatique; et
- E — représente le reste d'un monoalcool ou polyol aromatique; et
- m — est 1 ou 2 et
- n, o et p — sont, indépendamment les uns des autres, 0 ou 1;

et présentent une teneur en silicium de 7 à 30 % en poids.

**2.** Liant selon la revendication 1, caractérisé en ce qu'il contient, en tant que groupes A, des groupes silanyle de formule générale III

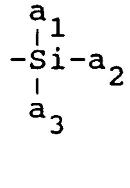

(III)

dans laquelle

- $a_1$-$a_3$ — sont R, $-SiR_3$ et $-Si_2R_5$, R représentant un groupe alkyle en $C_1$-$C_3$, en particulier méthyle, et/ou un groupe aryle, en particulier phényle, étant entendu qu'au moins l'un des radicaux

$a_1$ à $a_3$ est $-SiR_3$ et que pas plus d'un de ces radicaux n'est $-Si_2R_5$.

3. Liant selon la revendication 2, caractérisé en ce qu'il contient des groupes silanyle qui contiennent 2 ou 3 atomes de silicium et/ou qui comportent en tant que radical R un groupe alkyle en $C_1$-$C_3$, en particulier méthyle.

4. Liant selon la revendication 1, caractérisé en ce que le groupe fonctionnel C est un groupe époxy qui est éventuellement lié par l'intermédiaire d'un groupe alkylène ou oxaéthano, un groupe aziridino ou carboxy, ou l'un de ses dérivés tel qu'ester, chlorure d'acide carboxylique, carbamoyle, anhydride, lactone ou lactame, ainsi qu'un groupe isocyanate ou carbodiimide.

5. Liant selon la revendication 1, caractérisé en ce que les groupes D dérivent d'alcools aliphatiques mono- à hexavalents, qui sont éventuellement éthérifiés avec d'autres alcools, en particulier ceux de même valence.

6. Liant selon la revendication 1, caractérisé en ce que les groupes E dérivent d'alcools aromatiques mono- à pentavalents, en particulier d'alcools aromatiques tri- à pentavalents.

7. Procédé pour la préparation d'un liant selon une ou plusieurs des revendications 1 à 6, caractérisé en ce qu l'on fait réagir le liant non modifié avec le réactif de silylation de formule générale I, dans un solvant aprotique et, en particulier lorsque le groupe C est un groupe isocyanate, la réaction est effectuée en présence d'un catalyseur.

8. Procédé selon la revendication 7, caractérisé en ce que l'on fait réagir le liant, avant la silylation avec le réactif de greffage de formule générale II, dans un solvant aprotique, à une température de 60 à 90 ° C.

9. Procédé selon la revendication 7, caractérisé en ce que l'on fait réagir le liant, après la silylation avec le réactif de greffage de formule générale II, dans un solvant aprotique, à une température de plus de 60 ° C.

10. Procédé selon la revendication 8 ou 9, caractérisé en ce que l'on effectue la réaction en présence d'un catalyseur.

11. Composition photosensible, essentiellement constituée d'un composé photosensible ou d'un système photosensible et d'un liant, caractérisée en ce que le liant comprend un liant selon une ou plusieurs des revendications 1 à 6.

12. Composition photosensible selon la renvendication 11, caractérisée en ce qu'elle contient, en tant que composé photosensible, un o-quinonediazide, et travaille en positif.

13. Composition photosensible selon la renvendication 11, caractérisée en ce qu'elle contient, en tant que système photosensible, un composé formant un acide fort sous l'effet d'un rayonnement actinique, et un composé dissociable par un acide, et travaille en positif.

14. Composition photosensible selon la revendication 11, caractérisée en ce qu'elle contient, en tant que composé photosensible, un composé azido aromatique, et travaille en négatif.

15. Matériau de reprographie photosensible, essentiellement constitué d'un support, éventuellement d'une couche de planage appliquée sur celui-ci et d'une couche photosensible, caractérisé en ce que la couche photosensible est constituée de la composition photosensible selon une ou plusieurs des revendications 11 à 14.

16. Matériau de reprographie photosensible selon la revendication 15, caractérisé en ce que la couche de planage peut être éliminée par attaque par ions réactifs.

17. Matériau de reprographie photosensible selon la revendication 15 ou 16, caractérisé en ce que la couche de planage est constituée d'une résine Novolaque, d'un polyimide, d'un résist positif à base de Novolaque traité thermiquement, d'un polystyrène, d'un poly[(méth)acrylate de méthyle] ou d'un poly-

(acétate de vinyle).